# EUROPÄISCHE PATENTSCHRIFT

(11) **EP 2 279 537 B1**
(45) Veröffentlichungstag und Bekanntmachung des Hinweises auf die Patenterteilung: **03.06.2015**
(21) Anmeldenummer: 09756304.3
(22) Anmeldetag: 18.11.2009
(51) Int. Cl.: H01L 51/52, C03C 27/10, C09J 153/02, C09J 153/00

(54) **VERFAHREN ZUR KAPSELUNG EINER ELEKTRONISCHEN ANORDNUNG**
METHOD FOR ENCAPSULATING AN ELECTRONIC ARRANGEMENT
PROCÉDÉ D'ENCAPSULAGE D'UN DISPOSITIF ÉLECTRONIQUE

(30) Priorität: 03.12.2008 DE 102008060113
(43) Veröffentlichungstag der Anmeldung: 02.02.2011
(73) Patentinhaber: TESA SE, 20253 Hamburg (DE)
(72) Erfinder: KRAWINKEL, Thorsten, 22457 Hamburg (DE); KEITE-TELGENBÜSCHER, Klaus, 22529 Hamburg (DE); ELLINGER, Jan, 20257 Hamburg (DE); STEEN, Alexander, 53175 Bonn (DE)
(86) Internationale Anmeldenummer: PCT/EP2009/065393
(87) Internationale Veröffentlichungsnummer: WO 2010/063579

(56) Entgegenhaltungen:
- EP-A- 1 674 432
- EP-A- 1 743 928
- EP-A- 1 900 771
- US-A1- 2006 100 299

## Beschreibung

Die vorliegende Erfindung betrifft ein Verfahren zur Kapselung einer elektronischen Anordnung gemäß dem Oberbegriff von Anspruch 1 sowie die Verwendung einer Haftklebemasse zur Kapselung einer elektronischen Anordnung gemäß dem Oberbegriff von Anspruch 6.

(Opto-)Elektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren, wie Hochdruck, Tiefdruck, Siebdruck, Flachdruck oder auch so genanntes "non impact printing", wie etwa Thermotransferdruck, Tintenstrehldruck oder Digitaldruck. Vielfach werden aber auch auch Vakuumverfahren, wie z.B. Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung, verwendet, wobei die Strukturierung in der Regel durch Masken erfolgt.

Als Beispiele für bereits kommerzielle oder in ihrem Marktpotential interessante (opto-) elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenzlampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und Selen, organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Als technische Herausforderung für die Realisierung einer ausreichenden Lebensdauer und Funktion von (opto-)elektronischen Anordnungen im Bereich der anorganischen und/oder organischen (Opto-)Elektronik, ganz besonders im Bereich der organischen (Opto-) Elektronik, ist ein Schutz der darin enthaltenen Komponenten vor Permeanten zu sehen. Permeanten können eine Vielzahl von niedermolekularen organischen oder anorganischen Verbindungen sein, insbesondere Wasserdampf und Sauerstöff.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So kann sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere bei der organischen (Opto-)Elektronik, gibt es besonderen Bedarf für flexible Klebelösungen, die eine Permeationsbarriere für Permeanten, wie Sauerstoff und/oder Wasserdampf, darstellen. Daneben gibt es eine Vielzahl von weiteren Anforderungen für derartige (opto-)elektronische Anordnungen. Die flexiblen Klebelösungen sollen daher nicht nur eine gute Haftung zwischen zwei Substraten erzielen, sondern zusätzlich Eigenschaften wie hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen.

Ein nach dem Stand der Technik gängiger Ansatz ist deshalb, die elektronische Anordnung zwischen zwei für Wasserdampf und Sauerstoff undurchlässige Substrate zu legen. Anschließend erfolgt dann eine Versiegelung an den Rändern. Für unflexible Aufbauten werden Glas oder Metallsubstrate verwendet, die eine hohe Permeationsbarriere bieten, aber sehr anfällig für mechanische Belastungen sind. Ferner verursachen diese Substrate eine relativ große Dicke der gesamten Anordnung. Im Falle von Metallsubstraten besteht zudem keine Transparenz. Für flexible Anordnungen hingegen kommen Flächensubstrate, wie transparente oder nicht transparente Folien, zum Einsatz, die mehrlagig ausgeführt sein können. Hierbei können sowohl Kombinationen aus verschieden Polymeren, als auch anorganische oder organische Schichten verwendet werden. Der Einsatz solcher Flächensubstrate ermöglicht einen flexiblen, äußert dünnen Aufbau. Dabei sind für die verschiedenen Anwendungen unterschiedlichste Substrate, wie z.B. Folien, Gewebe, Vliese und Papiere oder Kombinationen daraus möglich.

Um eine möglichst gute Versiegelung zu erzielen werden spezielle Barriereklebemassen verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen. Eine geringe Haftung auf der Anordnung verringert die Barrierewirkung an der Grenzfläche, wodurch ein Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff bzw. Wasserdampf durch einen Film unter spezifischen Bedingungen von Temperatur und Partialdruck sowie ggf. weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR sondern beinhaltet immer auch eine Angabe zur mittleren Weglänge der Permeation, wie z.B. die Dicke des Materials, oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und einen definierten Permeanten unter stationären Bedingungen bei bestimmter Permeationsweglänge, Partialdruck und Temperatur. Die Permeabilität P ist das Produkt aus Diffusions-Term D und Löslichkeits-Term S: P = D * S

Der Löslichkeitsterm S beschreibt vorliegend die Affinität der Barriereklebemasse zum Permeanten. Im Fall von Wasserdampf wird beispielsweise ein geringer Wert für S von hydrophoben Materialen erreicht. Der Diffusionsterm D ist ein Maß für die Beweglichkeit des Permeanten im Barrierematerial und ist direkt abhängig von Eigenschaften, wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ansätze, um die Barrierewirkung einer Klebemasse zu erhöhen, müssen die beiden Parameter D und S insbesondere im Hinblick auf den Einfluss auf die Durchlässigkeit von Wasserdampf und Sauerstoff berücksichtigen. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Ein geringer Löslichkeits-Term S ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeits-Term), weisen aber durch ihre frei drehbare Si-O Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeits-Term S und Diffusions-Term D notwendig.

Hierfür wurden bisher vor allem Flüssigklebstoffe und Adhäsive auf Basis von Epoxiden verwendet (WO98/21287 A1; US 4,051,195 A; US 4,552,604 A). Diese haben durch eine starke Vernetzung einen geringen Diffusionsterm D. Ihr Haupteinsatzgebiet sind Randverklebungen starrer Anordnungen, aber auch mäßig flexible Anordnungen. Eine Aushärtung erfolgt thermisch oder mittels UV-Strahlung. Eine vollflächige Verklebung ist aufgrund des durch die Aushärtung auftreten Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOC - volatile organic compound) die empfindlichen elektronischen Strukturen der Anordnung schädigen und den Umgang in der Produktion erschweren. Der Klebstoff muss aufwendig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringer Flexibilität auf. Der Einsatz von thermisch-vernetzenden Systemen wird im niedrigen Temperaturbereich oder bei 2-Komponenten-Systemen durch die Topfzeit begrenzt, also die Verarbeitungszeit bis eine Vergelung stattgefunden hat Im hohen Temperaturbereich und insbesondere bei langen Reaktionszeiten begrenzen wiederum die empfindlichen (opto-) elektronischen Strukturen die Verwendbarkeit derartiger Systeme - die maximal anwendbaren Temperaturen bei (opto-)elektronischen Strukturen liegen oft bei 60°C, da bereits ab dieser Temperatur eine Vorschädigung eintreten kann. Insbesondere flexible Anordnungen, die organische Elektronik enthalten und mit transparenten Polymerfolien oder Verbunden aus Polymerfolien und anorganischen Schichten gekapselt sind, setzen hier enge Grenzen. Dies gilt auch für Laminierschritte unter großem Druck. Um eine verbesserte Haltbarkeit zu erreichen, ist hier ein Verzicht auf einen temperaturbelastenden Schritt und eine Laminierung unter geringerem Druck von Vorteil.

Alternativ zu den thermisch härtbaren Flüssigklebstoffen werden mittlerweile vielfach auch strahlenhärtende Klebstoffe eingesetzt (US 2004/0225025 A1). Die Verwendung von strahlenhärtenden Klebstoffen vermeidet eine lange andauernde Wärmebelastung der elektronischen Anordnung. Jedoch kommt es durch die Bestrahlung zu einer kurzfristigen punktuellen Erhitzung der Anordnung, da neben einer UV-Strahlung in der Regel auch ein sehr hoher Anteil an IR-Strahlung emittiert wird. Weitere oben genannte Nachteile von Flüssigklebstoffen wie VOC, Schrumpf, Delamination und geringe Flexibilität bleiben ebenfalls erhalten. Probleme können durch zusätzliche flüchtige Bestandteile oder Spaltprodukte aus den Photoinitiatoren oder Sensitizern entstehen. Zudem muss die Anordnung durchlässig für UV-Licht sein.

Da Bestandteile insbesondere organischer Elektronik und viele der eingesetzten Polymere häufig empfindlich gegen UV-Belastung sind, ist ein länger andauernder Außeneinsatz nicht ohne weitere zusätzliche Schutzmaßnahmen, etwa weitere Deckfolien möglich. Diese können bei UV-härtenden Klebesystemen erst nach der UV-Härtung aufgebracht werden, was die Komplexität der Fertigung und die Dicke der Anordnung zusätzlich erhöht.

Die US 2006/0100299 A1 offenbart ein UV-härtbares Haftklebeband zur Kapselung einer elektronischen Anordnung. Das Haftklebeband weist eine Klebemasse auf Basis einer Kombination eines Polymers mit einem Erweichungspunkt von größer 60°C, eines polymerisierbaren Epoxidharzes mit einem Erweichungspunkt von unter 30°C und einem Photoinitiator auf. Bei den Polymeren kann es sich um Polyurethan, Polyisobutylen, Polyacrylnitril, Polyvinylidenchlorid, Poly(meth)acrylat oder Polyester, insbesondere aber um ein Acrylat handeln. Des Weiteren sind Klebharze, Weichmacher oder Füllstoffe enthalten.

Acrylatmassen haben eine sehr gute Beständigkeit gegenüber UV-Strahlung und verschiedenen Chemikalien, besitzen aber sehr unterschiedliche Klebkräfte auf verschiedenen Untergründen. Während die Klebkraft auf polaren Untergründen wie Glas oder Metall sehr hoch ist, ist die Klebkraft auf unpolaren Untergründen wie beispielsweise Polyethylen oder Polypropylen eher gering. Hier besteht die Gefahr der Diffusion an der Grenzfläche in besonderem Maße. Zudem sind diese Massen sehr polar, was eine Diffusion insbesondere von Wasserdampf, trotz nachträglicher Vernetzung, begünstigt. Durch den Einsatz polymerisierbarer Epoxidharze wird diese Tendenz weiter verstärkt.

Die in US 2006/0100299 A1 genannte Ausführung als Haftklebemasse hat den Vorteil einer einfachen Applikation, leidet aber ebenfalls unter möglichen Spaltprodukten durch die enthaltenen Photoinitiatoren, einer zwangsläufigen UV-Durchlässigkeit des Aufbaus und einer Verringerung der Flexibilität nach der Aushärtung. Zudem ist durch den geringen Anteil an Epoxidharzen oder anderen Vernetzern, der für eine Erhaltung der Haftklebrigkeit und insbesondere der Kohäsion notwendig ist, eine nur sehr viel geringere Vernetzungsdichte als mit Flüssigklebern erreichbar.

Haftklebebänder benötigen in der Regel durch die relativ hochmolekularen Polymere im Gegensatz zu Flüssigklebstoffen für eine gute Benetzung und Haftung auf der Oberfläche eine gewisse Zeit, ausreichenden Druck und eine gute Balance zwischen viskosem Anteil und elastischen Anteil. Allgemein führt das nachträgliche Vernetzen der Klebemassen zu einem Schrumpf der Masse. Dies kann zu einer Verringerung der Haftung an der Grenzfläche führen und wiederum die Permeabilität erhöhen.

Die WO 2007/087281 A1 offenbart ein transparentes flexibles Haftklebeband auf Basis von Polyisobutylen (PIB) für elektronische Anwendungen, insbesondere OLED. Dabei wird Polyisobutylen mit einem Molekulargewicht von mehr als 500.000 g/mol und ein hydriertes cyclisches Harz verwendet. Optional ist der Einsatz eines photopolymerisierbaren Harzes und eines Photoinitiators möglich.

Klebemassen auf der Basis von Polyisobutylen weisen aufgrund ihrer geringen Polarität eine gute Barriere gegen Wasserdampf auf, haben aber selbst bei hohen Molekulargewichten eine relativ geringe Kohäsivität, weshalb schon bei Raumtemperatur und insbesondere bei erhöhten Temperaturen, unter Belastung eine Kriechneigung festgestellt werden kann und sie deshalb eine geringe Scherfestigkeit aufweisen. Der Anteil an niedermolekularen Bestandteilen kann nicht beliebig reduziert werden, da sonst die Haftung deutlich verringert wird und die Grenzflächenpermeation zunimmt. Bei Einsatz eines hohen Anteils an funktionellen Harzen, der aufgrund der sehr geringen Kohäsion der Masse notwendig ist, wird die Polarität der Masse wieder erhöht und damit der Löslichkeits-Term vergrößert.

Demgegenüber zeigt eine Haftklebemasse mit ausgeprägter Vernetzung zwar gute Kohäsion, doch ist das Auffließverhalten beeinträchtigt. Die Haftklebemasse kann sich nur unzureichend an die Rauhigkeit einer Substratoberfläche anpassen, wodurch die Permeation an der Grenzfläche erhöht ist. Zudem kann eine Haftklebemasse mit ausgeprägter Vernetzung nur in geringerem Maße Verformungsenergie, wie sie unter Belastung auftritt, dissipieren. Durch beide Phänomene wird die Klebkraft reduziert. Eine geringfügig vernetzte Haftklebemasse kann dagegen zwar gut auf raue Oberflächen auffließen und Verformungsenergie dissipieren, so dass die Anforderungen an die Adhäsion erfüllt sein können, jedoch widersteht die Haftklebemasse auf Grund einer reduzierten Kohäsion nur unzureichend einer Belastung.

Aus dem Stand der Technik ist zudem eine Haftklebemasse ohne Barriereeigenschaften bekannt (WO 03/065470 A1), die in einem elektronischen Aufbau als Transferklebemasse verwendet wird. Die Klebemasse enthält einen funktionellen Füllstoff, der mit Sauerstoff oder Wasserdampf innerhalb des Aufbaus reagiert. Damit ist eine einfache Applikation eines Scavengers innerhalb des Aufbaus möglich. Für die Versiegelung des Aufbaus nach Außen wird ein weiteres Adhäsiv mit geringer Durchlässigkeit verwendet.

Aus dem Stand der Technik ist eine Klebemasse auf Basis von Vinylaromatenblockcopolymeren beispielsweise aus der US 4,985,499 A1 bekannt. Diese Schrift beschreibt verschiedene vorteilhafte Zusammensetzungen der Klebemasse.

Ferner ist aus dem Stand der Technik die Barrierewirkung von Blockcopolymeren bekannt US 2002/0188053 A1). Hier werden Polymere auf dieser Basis für die Versiegelung von elektrophoretischen Displays eingesetzt, indem die aktiven Substanzen nach deren Aufbringung mit einer Lösung des Polymers überzogen werden, die nach dem Trocknen als Siegelschicht und Fixierung wirkt. Diese Polymere weisen keine selbstklebenden Eigenschaften auf und erreichen eine Haftung an den anderen Komponenten des elektrophoretischen Displayaufbaus nur durch die Benetzung aus der Lösung. Dies bedingt den Einsatz von Lösemitteln, erzeugt Emissionen und ist in der Dosierung schwierig.

Aufgabe der vorliegenden Erfindung ist es ein Verfahren zur Kapselung einer elektronischen Anordnung gegen Permeanten, insbesondere Wasserdampf und Sauerstoff, anzugeben, dass einfach durchführbar ist und mit dem gleichzeitig eine gute Kapselung erzielt wird. Ferner soll die Lebensdauer von (opto-) elektronischen Anordnungen durch die Verwendung einer geeigneten, insbesondere flexiblen, Klebemasse erhöht werden.

Die vorliegende Erfindung löst das zuvor beschriebene Problem durch ein Verfahren gemäß Anspruch 1. Nebengeordnete Lösungen beschreiben die Patentansprüche 6 und 19. Bevorzugte Ausgestaltungen und Weiterbildungen sind Gegenstand der jeweiligen Unteransprüche.

Die vorliegende Erfindung beruht zunächst auf der Erkenntnis, dass es trotz der zuvor beschriebenen Nachteile möglich ist, eine Haftklebemasse zur Kapselung einer elektronischen Anordnung zu verwenden, bei der die zuvor bzgl. Haftklebemassen beschriebenen Nachteile nicht oder nur vermindert auftreten. Es hat sich nämlich gezeigt, dass eine Haftklebemasse auf Basis von Butylenblockcopolymeren, insbesondere von Isobutylenblockcopolymeren zur Kapselung elektronischer Anordnungen besonders geeignet ist. Erfindungsgemäß wird entsprechend eine Haftklebemasse auf Basis von Butylenblockcopolymeren bereitgestellt und auf die zu kapselnden Bereiche der elektronischen Anordnung appliziert. Da es sich bei der Klebemasse um eine Haftklebemasse handelt, ist die Applikation besonders einfach, da keine Vorfixierung oder dgl. erfolgen muss. Je nach Ausgestaltung der Haftklebemasse ist auch keine nachfolgende Behandlung mehr erforderlich. Auch kann durch die Darreichung als Haftklebeband die Menge der Haftklebemasse einfach dosiert werden und es fallen auch keine Lösemittelemissionen an.

Eine Haftklebemasse auf Basis von Butylenblockcopolymeren bedeutet insbesondere eine Haftklebemasse, bei der der Gesamtanteil der Blockcopolymere mindestens 40 Gew.-% beträgt, bevorzugt mindestens 55 Gew.-%.

Im Bereich der Klebstoffe zeichnen sich Haftklebemassen insbesondere durch ihre permanente Klebrigkeit und Flexibilität aus. Ein Material, das permanente Haftklebrigkeit aufweist, muss zu jedem Zeitpunkt eine geeignete Kombination aus adhäsiven und kohäsiven Eigenschaften aufweisen. Diese Charakteristik unterscheidet die Haftklebemassen beispielsweise von reaktiven Klebstoffen, die im nicht ausreagierten Zustand kaum Kohäsion bieten. Für gute Haftungseigenschaften gilt es, Haftklebemassen so einzustellen, dass eine optimale Balance aus adhäsiven und kohäsiven Eigenschaften besteht.

Als Kapselung wird vorliegend nicht nur ein vollumfänglicher Einschluss mit der genannten Haftklebemasse bezeichnet sondern auch bereits eine bereichsweise Applikation der Haftklebemasse auf den zu kapselnden Bereichen der (opto-) elektronischen Anordnung, beispielsweise eine einseitige Überdeckung oder eine Umrahmung einer elektronischen Struktur.

Durch die Auswahl der Bestandteile der Haftklebemasse und die dadurch sehr geringe Polarität resultierend aus einem unpolaren Butylenblock, insbesondere einem Polyisobutylenblock des Isobutylenblockcopolymeren, und dem daraus resultierenden niedrigen Löslichkeits-Term (S) des Diffusionskoeffizienten wird ein niedriges Durchtrittvermögen von Permeanten wie Wasserdampf und Sauerstoff erreicht, insbesondere von Wasserdampf. Im Vergleich zu anderen Haftklebemassen wird zusätzlich eine weitere Verringerung der Sauerstoffpermeabilität erreicht.

Durch die Bildung von zumindest zwei Domänen innerhalb des Blockcopolymers erhält man, insbesondere im Vergleich zu Klebemassen auf Basis von Polyisobutylen zusätzlich eine sehr gute Kohäsion und gleichzeitig verbesserte Barriereeigenschaften. Durch weitere Komponenten, wie nachfolgend beschrieben, können je nach Anforderungen der (opto-) elektronischen Anordnung, etwa durch eine Vernetzungsreaktion, die Eigenschaften vorteilhaft an die Anforderungen angepasst werden.

Vorteil der hier vorliegenden Erfindung ist also, im Vergleich zu anderen Haftklebemassen, die Kombination aus sehr guten Barriereeigenschaften gegenüber Sauerstoff und vor allem gegenüber Wasserdampf bei gleichzeitiger guter Grenzflächenhaftung auf unterschiedlichen Substraten, guten kohäsive Eigenschaften und, im Vergleich zu Flüssigklebstoffen, eine sehr hohe Flexibilität und eine einfache Applikation in der (opto-)elektronischen Anordnung und bei/in der Kapselung. Je nach Ausführung der Haftklebemasse bieten Klebemassen auf Basis von Isobutylenblockcopolymeren eine gute Beständigkeit gegenüber Chemikalien und Umwelteinflüssen, insbesondere bei Bewitterung und UV-Belastung. Des Weiteren liegen in bestimmten Ausführungen auch transparente Klebemassen vor, die in besonderer Weise für den Einsatz in (opto-)elektronischen Anordnungen Anwendung finden können, da eine Verminderung von einfallendem oder austretendem Licht sehr gering gehalten wird.

Die Haftklebemasse auf Basis von Butylenblockcopolymeren, insbesondere von Isobutylenblockcopolymeren, zeichnet sich also, neben guter Verarbeitbarkeit und Beschichtbarkeit, durch gute Produkteigenschaften in Bezug auf Adhäsion und Kohäsion aus sowie durch eine gute Barrierewirkung gegenüber Sauerstoff und eine sehr gute Barrierewirkung gegenüber Wasserdampf, insbesondere im Vergleich zu Haftklebemassen auf Basis von Acrylaten, Silikonen, Polyisobutylen, Vinylaromatenblockcopolymeren aus Styrol (A-Blöcke) und 1,3-Dienen (B-Blöcke) sowie deren hydrierten Varianten oder Vinylacetat. Eine derartige Haftklebemasse kann auf einfache Weise in eine elektronische Anordnung integriert werden, insbesondere auch in solche Anordnung, die hohe Flexibilität erfordert. Weitere besonders vorteilhafte Eigenschaften der Haftklebemasse sind ähnlich gute Haftung auf unterschiedlichen Substraten, hohe Scherfestigkeit und hohe Flexibilität. Durch eine sehr gute Haftung am Substrat wird zudem auch eine geringe Grenzflächenpermeation erzielt. Durch die Verwendung der hier beschriebenen Formulierungen für die Verkapselung von (opto-)elektronischen Strukturen werden vorteilhafte Anordnungen gewonnen, die die oben genannten Vorteile vereinen und den Verkapselungsprozess dadurch beschleunigen und vereinfachen.

Da in bestimmten Ausführungen der Haftklebemasse keine thermischen Prozessschritte und/oder keine Bestrahlung notwendig sind, kein Schrumpf durch eine Vernetzungsreaktion auftritt und die Haftklebemasse als bahnförmiges Material oder in einer der elektronischen Anordnung entsprechend angepassten Form vorliegt, kann die Masse einfach und schnell mit geringem Druck, wie er bei der Applikation von Haftklebemassen üblich ist, in den Verkapselungsprozess des (opto-) elektronischen Aufbaus integriert werden. Die üblicherweise mit den vermiedenen Verarbeitungsschritten einhergehenden Nachteile, wie thermische und mechanische Belastungen, können so minimiert werden. Eine Verkapselung durch Lamination von zumindest Teilen der (opto-)elektronischen Aufbauten mit einem flächigen Barrierematerial (z.B. Glas, insbesondere Dünnglas, metalloxidbeschichteten Folien, Metallfolien, Multilayer-Substratmaterialien) ist mit sehr guter Barrierewirkung in einem einfachen Rolle-zu-Rolle Prozess möglich. Die Flexibilität des gesamten Aufbaus hängt, neben der Flexibilität der Haftklebemasse von weiteren Faktoren, wie Geometrie und Dicke der (opto-)elektronischen Aufbauten bzw. der flächigen Barrierematerialien ab. Die hohe Flexibilität der Haftklebemasse ermöglicht es aber sehr dünne, biegsame und flexible (opto-)elektronische Aufbauten zu realisieren. Unter dem benutzten Begriff "biegsam" ist die Eigenschaft zu verstehen, dass der Krümmung eines gebogenen Gegenstands wie einer Trommel mit bestimmtem Radius, insbesondere mit einem Radius von 1 mm, ohne Beschädigung gefolgt wird.

Von besonderem Vorteil für die Kapselung von (opto-)elektronischen Aufbauten ist es, wenn diese vor, während oder nach der Applikation der Haftklebemasse erwärmt werden. Dadurch kann die Haftklebemasse besser auffließen und somit die Permeation an der Grenzfläche zwischen der (opto-)elektronischen Anordnung und der Haftklebemasse vermindert werden. Die Temperatur sollte dabei bevorzugt mehr als 30°C, weiter bevorzugt mehr als 50°C betragen, um das Auffließen entsprechend zu fördern. Zu hoch sollte die Temperatur jedoch nicht gewählt werden, um die (opto-)elektronische Anordnung nicht zu beschädigen. Die Temperatur sollte möglichst weniger als 100°C betragen. Als optimaler Temperaturbereich haben sich Temperaturen zwischen 50°C und 70°C herausgestellt. Vorteilhaft ist es ebenso, wenn die Haftklebemasse vor, währen oder nach der Applikation zusätzlich oder alternativ erwärmt wird.

In bevorzugter Ausgestaltung eines Verfahrens zur Kapselung einer elektronischen Anordnung gegen Permeanten kann die Haftklebemasse als Bestandteil eines Klebebandes bereitgestellt werden. Diese Darreichungsart erlaubt eine besonders einfache und gleichmäßige Applikation der Haftklebemasse.

Der allgemeine Ausdruck "Klebeband" umfasst dabei in einer Ausführungsform ein Trägermaterial, welches ein- oder beidseitig mit einer Haftklebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge, Mehrschichtanordnungen und dergleichen. Dabei sind für verschiedene Anwendungen unterschiedlichste Träger, wie z.B. Folien, Gewebe, Vliese und Papiere mit den Klebmassen kombinierbar. Des Weiteren umfasst der Ausdruck "Klebeband" auch so genannte "Transferklebebänder", d.h. ein Klebeband ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Haftklebemasse kann so direkt zur Verbindung zweier Oberflächen in (opto-)elektronischen Anordnungen verwendet werden.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien / Folienverbunde können aus allen gängigen zur Folienherstellung verwendeten Kunststoffen bestehen, beispielhaft aber nicht einschränkend erwähnt seien:
Polyethylen, Polypropylen - insbesondere das durch mono-oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Der Träger kann zudem mit organischen oder anorganischen Beschichtungen oder Schichten kombiniert sein. Dies kann durch übliche Verfahren, wie z.B. Lackieren, Drucken, Bedampfen, Sputtern, Co-Extrusion oder Lamination geschehen. Beispielhaft, aber nicht einschränkend erwähnt seien hier etwa Oxide oder Nitride des Siliziums und des Aluminiums, Indium-Zinn-Oxid (ITO) oder Sol-Gel-Beschichtungen.

Besonders bevorzugt sind diese Folien / Folienverbunde, insbesondere die Polymerfolien mit einer Permeationsbarriere für Sauerstoff und Wasserdampf versehen, wobei die Permeationsbarriere die Anforderungen für den Verpackungsbereich übertrifft (WVTR < 10⁻¹ g/(m²d); OTR < 10⁻¹ cm³/(m²d bar)). Die Bestimmung der Permeabilität für Sauerstoff (OTR) und Wasserdampf (WVTR) erfolgt nach DIN 53380 Teil 3 bzw. ASTM F-1249. Die Sauerstoffdurchlässigkeit wird bei 23°C und einer relativen Feuchte von 50% gemessen. Die Wasserdampfdurchlässigkeit wird bei 37,5°C und einer relativen Feuchte von 90% bestimmt. Die Ergebnisse werden auf eine Foliendicke von 50 µm normiert.

Zudem können die Folien / Folienverbunde in bevorzugter Ausgestaltung transparent ausgebildet sein, damit auch der Gesamtaufbau eines derartigen Klebeartikels transparent ausgebildet ist. "Transparenz" bedeutet dabei eine mittlere Transmission im sichtbaren Bereich des Lichts von mindestens 75%, bevorzugt höher als 90%.

Je nach Anforderungen der (opto-)elektronischen Anordnung können in einer bestimmten Ausführung der Haftklebemasse die elastischen und viskosen Eigenschaften, sowie die Barrierewirkung durch eine (nachträgliche) Vernetzungsreaktion variiert werden. Dies kann angepasst an die (opto-)elektronische Anordnung sowohl thermisch, als auch durch elektromagnetische Strahlung, bevorzugt UV-Strahlung, Elektronenstrahlung oder Gammastrahlung stattfinden. Dabei sollte die hohe Flexibilität der Haftklebemasse erhalten bleiben. Weiter bevorzugt erfolgt die Vernetzung, sofern erforderlich, vor der Applikation der Haftklebemasse auf der elektronischen Anordnung. Eine für die Vernetzung ggf. erforderliche Energiezufuhr, beispielsweise in Form von Wärme oder durch UV-Bestrahlung oder dgl., kann so die elektronischen Strukturen nicht beeinträchtigen.

Weiter bevorzugt kommt eine Haftklebemasse zum Einsatz, die in bestimmten Ausführungen im sichtbaren Licht des Spektrums (Wellenlängenbereich von etwa 400 nm - 800 nm) transparent ist. Die gewünschte Transparenz lässt sich insbesondere durch die Verwendung farbloser Klebharze erzielen. Eine derartige Haftklebemasse eignet sich somit auch für einen vollflächigen Einsatz über einer (opto-)elektronischen Struktur. Eine vollflächige Verklebung bietet, bei einer etwa mittigen Anordnung der elektronischen Struktur gegenüber einer Randversiegelung den Vorteil, dass der Permeant durch die gesamte Fläche diffundieren müsste, bevor er die Struktur erreicht. Der Permeationsweg ist somit deutlich erhöht. Die in dieser Ausführungsform verlängerten Permeationswege im Vergleich zur Randversiegelung etwa durch Flüssigklebstoffe wirken sich positiv auf die Gesamtbarriere aus, da der Permeationsweg umgekehrt proportional zur Durchlässigkeit ist.

"Transparenz" bedeutet dabei eine mittlere Transmission der Klebemasse im sichtbaren Bereich des Lichts von mindestens 75%, bevorzugt höher als 90%. Bei der Ausführung als Haftklebeband mit Träger hängt die die maximale Transmission des gesamten Aufbaus zudem von der Art des verwendeten Trägers und der Art des Aufbaus ab.

Die elektronischen Strukturen (opto-)elektronischer Anordnungen sind oftmals anfällig gegenüber UV-Strahlung. Als besonders vorteilhaft hat sich daher herausgestellt, wenn die Haftklebemasse zudem UV-blockend ausgebildet ist. Unter dem Begriff "UV-blockend" wird vorliegend ein mittlerer Transmissionsgrad von maximal 20%, vorzugsweise von maximal 10%, weiter bevorzugt von maximal 1% im entsprechenden Wellenlängenbereich bezeichnet. In bevorzugter Ausgestaltung ist die Haftklebemasse im Wellenlängenbereich von 320 nm bis 400 nm (UVA-Strahlung) UV-blockend ausgebildet, vorzugsweise im Wellenlängenbereich von 280 nm bis 400 nm (UVA- und UVB-Strahlung), weiter vorzugsweise im Wellenlängenbereich von 190 nm bis 400 nm (UVA-, UVB- und UVC-Strahlung).

Die UV-blockende Wirkung der Haftklebemasse kann insbesondere durch eine Zugabe von UV-Blockern oder geeigneten Füllstoffen zur Haftklebemasse erzielt werden. Als UV-Blocker eignen sich beispielsweise HALS (Hindert Armine Light Stabilizer) wie Tinuvin der Firma Ciba oder Benzimidazolderivaten. Als Füllstoff ist besonders Titandioxid geeignet, ganz besonders nanoskaliges Titandioxid, da hierdurch eine Transparenz, im sichtbaren Bereich beibehalten werden kann.

Die Haftklebemasse zeigt durch die verwendeten Butylenblöcke, insbesondere die Polyisobutylenblöcke, besonders im Vergleich zu Haftklebemassen basierend auf nicht oder nur teilhydrierten Copolymerblöcken eine sehr gute Beständigkeit gegen Witterungseinflüsse und UV-Licht. Diese Beständigkeit wird insbesondere durch Verwendung von hydrierten Harzen verbessert.

Die verwendete Haftklebemasse basiert, wie im Folgenden näher dargelegt wird, vorzugsweise auf mindestens einem Butylenblockcopolymere bevorzugt auf mindestens einem Isobutylenblockcopolymer, und enthält zudem einen Klebharz. In bestimmten Ausführungsformen werden weitere Blockcopolymere eingesetzt, wie sie im Folgenden beschrieben werden.

Als (Iso-)Butylenblockcopolymer kommen bevorzugt Blockcopolymere zum Einsatz, die zum einen Blöcke bevorzugt aus Vinylaromaten (A-Blöcke), wie zum Beispiel Styrol, und zum anderen solche gebildet durch Polymerisation von (Iso-)Butylen allein oder von (Iso-)Butylen in Kombination mit n-Buten oder 1,3-Dienen, wie Isopren oder Butadien, (B-Blöcke) enthalten. Die Anteile der 1,3-Dienene können teilweise, selektiv oder vollständig hydriert sein. Diese B-Blöcke weisen üblicherweise eine geringe Polarität auf. Bevorzugt werden als B-Blöcke reine (Poly-)Isobutylenblöcke verwendet.

Anstelle der bevorzugten Polystyrolblöcke als A-Blöcke können als Vinylaromaten auch Polymerblöcke auf Basis anderer aromatenhaltiger Homo- und Copolymere (bevorzugt C-8 bis C-12 Aromaten) mit Glasübergangstemperaturen von über 75°C verwendet werden, wie z.B. α-methylstyrolhaltige Aromatenblöcke. Weiterhin können auch gleiche oder unterschiedliche A-Blöcke enthalten sein.

In bestimmten Ausführungsformen ist die Verwendung der oben genannten B-Blöcke mit A-Blöcken von anderer chemischer Natur möglich, die eine Glasübergangstemperatur oberhalb der Raumtemperatur zeigen, wie zum Beispiel Polymethylmethacrylat.

Die Blockcopolymere besitzen die Struktur (AB)nX, wobei A beispielsweise die bevorzugten Vinylaromatenblöcke sind, B beispielsweise die bevorzugten Polyisobutylenblöcke und X eine Kopplungsstelle, n kann dabei Werte von 1 bis 8 annehmen. Bevorzugt nimmt n Werte von 2 bis 8 an. Die Blockcopolymere können also lineare A-B-A Struktur aufweisen, oder radial aufgebaut sein. Bei der Kopplungsstelle kann es sich beispielsweise um eine einfache C-C-Bindung handeln, es können aber auch andere Kopplungsstellen vorgesehen sein, z.B. Verbindungen mit einem Metallatom oder dgl.

Als (Iso-)Butylenblockcopolymere können auch Blockcopolymere verwendet werden, die neben den oben beschriebenen Blöcken A und B zumindest einen weiteren Block enthalten, wie z.B. A-B-C-Blockcoplymere.

Weiter bevorzugt werden Mischungen aus AB-Blockcopolymeren (2-Blöcke) und ABA-Blockcopolymeren (3-Blöcke) eingesetzt. Die Verwendung dieser Mischungen ermöglicht die Herstellung von Haftklebemassen mit verbessertem Auffließverhalten und Adhäsion.

Das Verhältnis von der 3-Blöcke zu den 2-Blöcken zueinander kann im Bereich zwischen 1:19 und 19:1 variieren.

Kommerziell sind geeignete Isobutylenblockcopolymere zum Beispiel unter dem Namen SiBStar der Firma Kaneka oder Oppanol IBS von BASF erhältlich.

In einer möglichen Ausgestaltung kann die erfindungsgemäße Haftklebemasse weitere Blockcoploymere als Bestandteil enthalten. Durch die Verwendung dieser im folgenden beschriebenen Blockcopolymere kann die Haftung der Klebemasse auf einem Substrat weiter erhöht werden. Dabei finden bevorzugt Vinylaromatenblockcoploymere auf Basis von Blockcopolymeren enthaltend Polymerblöcke überwiegend gebildet von Vinylaromaten (A2-Blöcke), bevorzugt Styrol, und solche überwiegend gebildet durch Polymerisation von 1,3-Dienen (B2-Blöcke), bevorzugt Butadien, Isopren oder einer Mischung aus beiden Monomeren, Verwendung. Diese B2-Blöcke weisen üblicherweise eine geringe Polarität auf. Sowohl Homo- als auch Copolymerblöcke sind als B2-Blöcke bevorzugt nutzbar.

Die aus den A2- und B2-Blöcken resultierenden Blockcopolymere können gleiche oder unterschiedliche B2-Blöcke enthalten, die teilweise, selektiv oder vollständig hydriert sein können. Die Blockcopolymere können lineare A2-B2-A2 Strukturen aufweisen. Einsetzbar sind ebenfalls Blockcopolymere von radialer Gestalt sowie sternförmige und lineare Multiblockcopolymere. Als weitere Komponenten können A2-B2 Zweiblockcopolymere vorhanden sein. Sämtliche der vorgenannten Polymere können alleine oder im Gemisch miteinander genutzt werden. Bevorzugt werden teilhydrierte oder hydrierte Polymere eingesetzt, um eine gute Witterungs- und UV-Stabilität zu erhalten.

Anstelle der als weitere Blockcopolymere bevorzugten Polystyrolblöcke können als Vinylaromaten auch Polymerblöcke auf Basis anderer aromatenhaltiger Homo- und Copolymere (bevorzugt C-8 bis C-12 Aromaten) mit Glasübergangstemperaturen von über 75°C verwendet werden, wie z.B. α-methylstyrolhaltige Aromatenblöcke. Weiterhin können auch gleiche oder unterschiedliche A2-Blöcke enthalten sein.

Verwendet werden können auch Blockcopolymere, die neben den oben beschriebenen Blöcken A2 und B2 zumindest einen weiteren Block enthalten, wie z.B. A2-B2-C2-Blockcoplymere.

Möglich, aber weniger bevorzugt ist auch die Verwendung der oben genannten B2-Blöcke mit A2-Blöcken von anderer chemischer Natur, die eine Glasübergangstemperatur oberhalb der Raumtemperatur zeigen, wie zum Beispiel Polymethylmethacrylat.

Kommerziell sind Vinylaromatenblockcopolymere zum Beispiel unter dem Namen Kraton der Fa. Kraton, (Kraton D 1101 und 1102 als Styrol-Butadien-Styrol-Blockcopolymere (SBS), Kraton D 1107 oder 1163 als Styrol-Isopren-Styrol-Blockcopolymere (SiS), oder Kraton G 1652 als hydriertes Styrol-Butadien-Styrol-Blockcopolymer), unter dem Namen Europrene der Fa. Polimeri Europa (Styrolblockcopolymere mit Isopren, Butadien oder deren Hydrierungsprodukten) oder unter dem Namen Septon der Fa. Kuraray (hydrierte Styrol-Isopren-styrol-Blockcopolymere) bekannt. A2-B2-C2-Vinylaromatenblockcopolymere sind z.B. unter dem Namen SBM von der Fa. Arkema erhältlich.

In einer vorteilhaften Ausführungsform weisen die Isobutylenblockcopolymere und weitere Vinylaromatenblockcopolymere jeweils einen Anteil von oben beschriebenen A-Blöcken bzw. A2-Blöcken von 10 Gew.-% bis 35 Gew.-% auf.

In einer weiteren bevorzugten Ausgestaltung beträgt der Anteil der Blockcopolymere in Summe bezogen auf die gesamte Haftklebmasse mindestens 20 Gew.-%, vorzugsweise mindestens 30 Gew.-%, weiter bevorzugt mindestens 35 Gew.-%. Ein zu geringer Anteil an Blockcopolymeren hat zur Folge, dass die Kohäsion der Haftklebemasse relativ niedrig ist. Der maximale Anteil der Blockcopolymere in Summe bezogen auf die gesamte Haftklebmasse beträgt maximal 70 Gew.-%. Ein zu hoher Anteil an Blockcopolymere hat wiederum zur Folge, dass die Haftklebemasse kaum noch haftklebrig ist.

Der Anteil der (Iso-)Butylenblockcopolymere am Gesamtanteil der Blockcopolymere beträgt mindestens 40 Gew.-%, bevorzugt mindestens 55 Gew.-%. Ein zu geringer Anteil an (Iso-)Butylenblockcopolymer hat zur Folge, dass die Barrierewirkung gegen Wasserdampf und Sauerstoff verringert wird.

In weiter bevorzugter Ausgestaltung weist die Haftklebemasse neben dem mindestens einem (Iso-)Butylenblockcopolymer, wie obenstehend beschrieben, mindestens ein Klebharz auf, um die Adhäsion in gewünschter Weise zu erhöhen. Das Klebharz sollte mit dem Elastomerblock der Blockcopolymere verträglich sein.

Als Klebrigmacher können in der Haftklebemasse zum Beispiel nicht hydrierte, partiell oder vollständig hydrierte Harze auf Basis von Kolophonium und Kolophoniumderivaten, hydrierte Polymerisate des Dicyclopentadiens, nicht hydrierte, partiell, selektiv oder vollständig hydrierte Kohlenwasserstoffharze auf Basis von C5-, C5/C9- oder C9-Monomerströmen, Polyterpenharze auf Basis von α-Pinen und/oder ss-Pinen und/oder δ-Limonen, hydrierte Polymerisate von bevorzugt reinen C8-und C9-Aromaten eingesetzt werden. Vorgenannte Klebharze können sowohl allein als auch im Gemisch eingesetzt werden. Dabei können sowohl bei Raumtemperatur feste als auch flüssige Harze zum Einsatz kommen. Um eine hohe Alterungs- und UV-Stabilität zu gewährleisten sind hydrierte Harze mit einem Hydrierungsgrad von mindestens 90%, vorzugsweise von mindestens 95%, bevorzugt.

Desweiteren sind unpolare Harze mit einem DACP-Wert (diacetone alcohol cloud point) oberhalb von 30°C und einem MMAP-Wert (mixed methylcylohexane aniline point) von größer 50°C, insbesondere mit einem DACP-Wert oberhalb von 37°C und einem MMAP-Wert größer 60°C bevorzugt. Der DACP-Wert und der MMAP-Wert geben jeweils die Löslichkeit in einem bestimmten Lösemittel an. Durch die Auswahl dieser Bereiche wird eine besonders hohe Permeationsbarriere, insbesondere gegen Wasserdampf, erreicht.

Weiter bevorzugt sind Harze mit einer Erweichungstemperatur (Ring/Kugel) von mehr als 95°C, insbesondere mehr als 100°C. Durch diese Auswahl wird eine besonders hohe Permeationsbarriere, insbesondere gegen Sauerstoff, erreicht.

Als weitere Additive können typischerweise genutzt werden:
- Plastifizierungsmittel, wie zum Beispiel Weichmacheröle, oder niedermolekulare flüssige Polymere, wie zum Beispiel niedermolekulare Polybutene
- primäre Antioxidanzien, wie zum Beispiel sterisch gehinderte Phenole
- sekundäre Antioxidanzien, wie zum Beispiel Phosphite oder Thioether
- Prozessstabilisatoren, wie zum Beispiel C-Radikalfänger
- Lichtschutzmittel, wie zum Beispiel UV-Absorber oder sterisch gehinderte Amine
   Verarbeitungshilfsmittel
- Endblockverstärkerharze sowie
- gegebenenfalls weitere Polymere von bevorzugt elastomerer Natur; entsprechend nutzbare Elastomere beinhalten unter anderem solche auf Basis reiner Kohlenwasserstoffe, zum Beispiel ungesättigte Polydiene wie natürliches oder synthetisch erzeugtes Polyisopren oder Polybutadien, chemisch im wesentlichen gesättigte Elastomere wie zum Beispiel gesättigte Ethylen-Propylen-Copolymere, α-Olefincopolymere, Polyisobutylen, Butylkautschuk, Ethylen-Propylenkautschuk, sowie chemisch funktionalisierte Kohlenwasserstoffe wie zum Beispiel halogenhaltige, acrylathaltige, allyl- oder vinyletherhaltige Polyolefine.

In einer weiteren Ausführung werden die erfindungsgemäß eingesetzten Haftklebemassen bevorzugt vor oder ggf. auch nach dem Auffließen auf die Oberfläche vernetzt, wobei solche Vernetzungsgrade angestrebt werden, die weiterhin eine hohe Flexibilität und gute Haftung des Materials ermöglichen. Nach der Vernetzung weist die Haftklebemasse bevorzugt eine Reißdehnung von mindestens 20% auf. Eine derartige Reißdehnung ist besonders bevorzugt im Hinblick auf eine möglichst flexible Ausgestaltung der Haftklebemasse. Die Reißdehnung wird bestimmt bei einer Dehngeschwindigkeit von 300 mm/min und einer Temperatur von 23°C.

In einer bevorzugten Vorgehensweise wird die Haftklebemasse mit UV-Strahlung oder Elektronenstrahlen vernetzt. Eine ausführliche Beschreibung des Standes der Technik und die wichtigsten Verfahrensparameter bezüglich der Vernetzung ist dem Fachmann beispielsweise aus "Chemistry and Technology of UV and EB formulation for Coatings, Inks and Paints" (Vol. 1, 1991, SITA, London) bekannt. Zudem können auch andere Verfahren eingesetzt werden, die hochenergetische Bestrahlung ermöglichen.

Zur Verringerung der erforderlichen Strahlendosis können dem viskoelastischen Material Vernetzer und/oder Promotoren zur Vernetzung beigemischt werden, insbesondere durch UV-, Elektronenstrahlen- und/oder thermisch anregbare Vernetzer und/oder Promotoren. Geeignete Vernetzer für die Strahlenvernetzung sind Monomere oder Polymere die beispielsweise folgende funktionelle Gruppen beinhalten: Acrylat oder Methacrylat, Epoxid, Hydroxy, Carboxy, Vinyl, Vinylether, Oxetan, Thiol, Acetoacetat, Isocyanate, Allyl oder allgemein ungesättigte Verbindungen. Die eingesetzten Monomere oder Polymere können, je nach den Anforderungen an den Vernetzungsgrad di- oder multifunktionell sein.

In einer weiteren bevorzugten Auslegung werden die Haftklebemassen mit thermisch aktivierbaren Vernetzern vernetzt. Hierzu werden bevorzugt Peroxide, Säure- oder Säureanhydride, Metallchelate, bi- oder multifunktionelle Epoxide, bi- oder multifunktionelle Hydroxide sowie bi- oder multifunktionelle Isocyanate beigemischt, wie sie etwa für Säureanhydride in EP 1311559 B1 beschrieben werden.

Neben den monomeren Vernetzern mit den beschriebenen funktionellen Gruppen werden bevorzugt Blockcopolymere eingesetzt, die mit diesen vernetzenden Gruppen funktionalisiert sind. Es werden vorteilhaft funktionalisierte Blockcopolymere wie die Kraton FG-Serie (etwa Kraton FG 1901 oder Kraton FG 1924), Asahi Tuftec M 1913 bzw. Tuftec M 1943 oder Septon HG252 (SEEPS-OH) eingesetzt. Des weiteren können auch die (Iso-)Butylenblockcopolymere selbst mit funktionellen Gruppen versehen sein, beispielsweise mit Maleinsäure und/oder Maliensäureanhydrid. Weitere bevorzugte Blockcopolymere sind zum Beispiel unter dem Namen Epofriend A 1005, A 1010 oder A 1020 der Firma Daicel erhältlich. Durch Zugabe geeigneter Vernetzungsagentien (zum Beispiel mehrwertige Isocyanate, Amine, Epoxide, Alkohole, Thiole, Phenole, Guanidine, Mercaptane Carbonsäuren bzw. Säureanhydride) können diese Blockcopolymere thermisch oder durch Strahlung vernetzt werden. Auch eine Kombination von säure- oder säureanhydridmodifizierten Blockcopolymer (zum Beispiel Kraton FG-Serie) und einem epoxidierten Blockcopolymer (zum Beispiel Daicel Epofriend-Serie) ist vorteilhaft nutzbar. Dadurch kann man eine Vernetzung ohne monomeren Vernetzer bewerkstelligen, wodurch auch bei unvollständiger Vernetzung keine monomeren Bestandteile übrig bleiben. Eine Mischung der funktionalisierten Monomere oder Polymere ist ebenfalls einsetzbar.

In einer Ausführungsform der vorliegenden Erfindung enthält die Haftklebemasse auch Füllstoffe, beispielhaft, aber nicht einschränkend erwähnt seien Oxide, Hydroxide, Carbonate, Nitride, Halogenide, Carbide oder gemischte Oxid-/ Hydroxid-/ Halogenidverbindungen des Aluminiums, Siliciums, Zirkoniums, Titans, Zinns, Zinks, Eisens oder der (Erd)alkalimetalle. Hierbei handelt es sich im wesentlichen um Tonerden z.B. Aluminiumoxide, Boehmit, Bayerit, Gibbsit, Diaspor und ähnliche. Ganz besonders geeignet sind Schichtsilicate wie beispielsweise Bentonit, Montmorillonit, Hydrotalcit, Hectorit, Kaolinit, Boehmit, Glimmer, Vermiculit oder deren Mischungen. Aber auch Ruße oder weitere Modifikationen des Kohlenstoffs, etwa Kohlenstoffnanoröhrchen können verwendet werden.

Bevorzugt werden als Füllstoffe der Haftklebmasse nanoskalige und/oder transparente Füllstoffe verwendet. Als nanoskalig wird ein Füllstoff vorliegend bezeichnet, wenn er in mindestens einer Dimension eine maximale Ausdehnung von etwa 100 nm, bevorzugt von etwa 10 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge bzw. die Breite der Kristallite kann aber bis zu einigen µm betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Haftklebemasse.

Durch den Aufbau labyrinthartiger Strukturen mithilfe der zuvor beschriebenen Füllstoffe in der Klebstoffmatrix wird der Diffusionsweg von zum Beispiel Sauerstoff und Wasserdampf derartig verlängert, dass ihre Permeation durch die Klebstoffschicht hindurch vermindert wird. Zur besseren Dispergierbarkeit dieser Füllstoffe in der Bindemittelmatrix können diese Füllstoffe mit organischen Verbindungen oberflächlich modifiziert: werden. Der Einsatz derartiger Füllstoffe an sich ist beispielsweise aus der US 2007/0135552 A1 sowie der WO 02/026908 A1 bekannt.

In einer weiteren vorteilhaften Ausführung der vorliegenden Erfindung werden auch Füllstoffe, die mit Sauerstoff und/oder Wasserdampf in besonderer Weise wechselwirken. können, eingesetzt. In die (opto-)elektronische Anordnung eindringender Sauerstoff oder Wasserdampf wird dann an diesen Füllstoffen chemisch oder physikalisch gebunden. Diese Füllstoffe werden auch als "getter", "scavenger", "desiccants" oder "absorber" bezeichnet. Solche Füllstoffe umfassen beispielhaft, aber nicht einschränkend: oxidierbare Metalle, Halide, Salze, Silicate, Oxide, Hydroxide, Sulfate, Sulfite, Carbonate von Metallen und Übergangsmetallen, Perchlorate und aktivierten Kohlenstoff, einschließlich seiner Modifikationen. Beispiele sind Cobaltchlorid, Calciumchlorid, Calciumbromid, Lithiumchlorid, Zinkchlorid, Zinkbromid, Siliciumdioxid (Silica Gel), Aluminiumoxid (aktiviertes Aluminium), Calciumsulfat, Kupfersulfat, Natriumdithionit, Natriumcarbonat, Magnesiumcarbonat, Titandioxid, Bentonit, Montmorillonit, Diatomenerde, Zeolithe und Oxide von (Erd)Alkalimetallen, wie Bariumoxid, Calciumoxid, Eisenoxid und Magesiumoxid oder auch Kohlenstoffnanoröhrchen. Desweiteren können auch organische Absorber, wie beispielsweise, Polyolefin-Copolymere, Polyamid-Copolymere, PET-Copolyester oder weitere auf Hybridpolymeren basierte Absorber, die meist in Kombination mit Katalysatoren wie beispielsweise Cobalt verwendet werden. Weitere organische Absorber sind etwa schwach vernetzte Polyacrylsäure, Ascorbate, Glucose, Gallussäure oder ungesättigte Fette und Öle.

Um eine möglichst gute Wirksamkeit der Füllstoffe hinsichtlich der Barrierewirkung zu erzielen sollte ihr Anteil nicht zu gering sein. Der Anteil beträgt vorzugsweise mindestens 5 Gew.-%, weiter bevorzugt mindestens 10 Gew.-% und ganz bevorzugt mindestens 15 Gew.-%. Typischerweise wird ein möglichst hoher Anteil von Füllstoffen eingesetzt, ohne dabei die Klebkräfte der Haftklebemasse zu stark herabzusetzen oder weitere Eigenschaften zu beeinträchtigen. Der Anteil beträgt daher in einer Auslegung maximal 95 Gew.-%, bevorzugt maximal 70 Gew.-%, weiter bevorzugt maximal 50 Gew.-%.

Des Weiteren ist eine möglichst feine Verteilung und möglichst hohe Oberfläche der Füllstoffe vorteilhaft. Dies ermöglicht einen höheren Wirkungsgrad und eine höhere Beladungskapazität und wird insbesondere mit nanoskaligen Füllstoffen erreicht.

Die Herstellung und Verarbeitung der Haftklebemasse kann aus Lösung, Dispersion sowie aus der Schmelze erfolgen. Bevorzugt erfolgt die Herstellung und Verarbeitung aus Lösung oder aus der Schmelze. Besonders bevorzugt ist die Fertigung der Klebmasse aus Lösung. Dabei werden die Bestandteile der Haftklebemasse in einem geeigneten Lösungsmittel, zum Beispiel Toluol oder Mischungen aus Benzin und Aceton, gelöst und mit allgemein bekannten Verfahren auf den Träger aufgebracht. Bei der Verarbeitung aus der Schmelze können dies Auftragsverfahren über eine Düse oder einen Kalander sein. Bei Verfahren aus der Lösung sind Beschichtungen mit Rakeln, Messern, Walzen oder Düsen bekannt, um nur einige zu nennen.

In einer bevorzugten Ausführung enthält die Haftklebemasse nicht mehr flüchtige organische Verbindungen (VOC) als 50 µg Kohlenstoff pro Gramm Masse, insbesondere nicht mehr als 10 µg C/g, gemessen nach VDA 277. Dies hat den Vorteil besserer Verträglichkeit mit den organischen Materialien des elektronischen Aufbaus sowie mit eventuell vorhandenen Funktionsschichten, wie z.B. einer transparenten leitfähige Metalloxidschicht oder einer solchen Schicht aus intrinsisch leitfähigem Polymer.

Die Haftklebemasse kann entweder zur vollflächigen Verklebung von (opto-)elektronischen Anordnungen verwendet werden oder nach entsprechender Konfektionierung können Stanzlinge, Rollen oder sonstige Formkörper aus der Haftklebemasse oder dem Haftklebeband hergestellt werden. Entsprechende Stanzlinge und Formkörper der Haftklebemasse / des Haftklebebandes werden dann vorzugsweise auf das zu verklebende Substrat aufgeklebt, etwa als Umrandungen oder Begrenzung einer (opto-)elektronischen Anordnung. Die Wahl der Form des Stanzlings oder des Formkörpers ist nicht eingeschränkt und wird abhängig von der Art der (opto-)elektronischen Anordnung gewählt. Die Möglichkeit der flächigen Laminierung ist, im Vergleich zu Flüssigklebstoffen durch die Erhöhung der Permeationsweglänge durch seitliches Eindringen der Permeanten von Vorteil für die Barriereeigenschaften der Masse, da die Permeationsweglänge sich umgekehrt proportional auf die Permeation auswirkt.

Sofern die Haftklebemasse in Form eines flächigen Gebildes mit einem Träger bereitgestellt wird, ist bevorzugt, dass die Dicke des Trägers bevorzugt im Bereich von etwa µm 1 bis etwa 350 µm liegt, weiter bevorzugt zwischen etwa 2 µm und etwa 250 µm und besonders bevorzugt zwischen etwa 12 µm und etwa 150 µm. Die optimale Dicke hängt von der (opto-) elektronischen Anordnung, der Endanwendung und der Art der Ausführung der Haftklebemasse ab. Sehr dünne Träger im Bereich von 1 bis 12 µm werden eingesetzt bei (opto-) elektronische Aufbauten, die eine geringe Gesamtdicke erreichen sollen, es wird jedoch der Aufwand für die Integration in den Aufbau erhöht. Sehr dicke Träger zwischen 150 und 350 µm werden eingesetzt wenn eine erhöhte Permeationsbarriere durch den Trägers und die Steifigkeit des Aufbaus im Vordergrund stehen; die Schutzwirkung wird durch den Träger erhöht, während die Flexibilität des Aufbaus verringert wird. Der bevorzugte Bereich zwischen 12 und 150 µm stellt für die meisten (opto-) elektronischen Aufbauten einen optimalen Kompromiss als Verkapselungslösung dar.

Weitere Einzelheiten, Ziele, Merkmale und Vorteile der vorliegenden Erfindung werden nachfolgend anhand bevorzugter Ausführungsbeispiele näher erläutert. In der Zeichnung zeigt
- Fig. 1: eine erste (opto-)elektronische Anordnung in schematischer Darstellung,
- Fig. 2: eine zweite (opto-)elektronische Anordnung in schematischer Darstellung,
- Fig. 3: eine dritte (opto-)elektronische Anordnung in schematischer Darstellung.

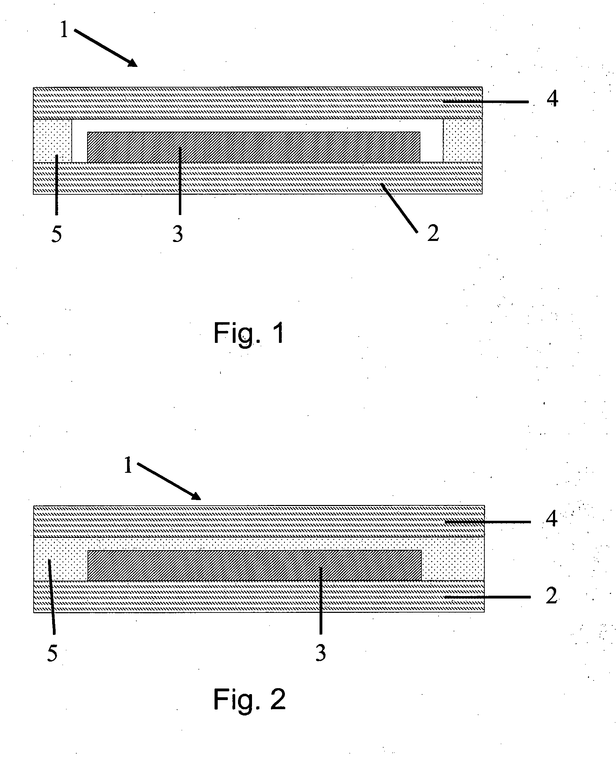

Fig. 1 zeigt eine erste Ausgestaltung einer (opto-)elektronischen Anordnung 1. Diese Anordnung 1 weist ein Substrat 2 auf, auf dem eine elektronische Struktur 3 angeordnet ist. Das Substrat 2 selbst ist als Barriere für Permeanten ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist eine Haftklebemasse 5 umlaufend neben der elektronischen Struktur 3 auf dem Substrat 2 vorgesehen. Die Haftklebemasse 5 verbindet die Abdeckung 4 mit dem Substrat 2. Durch eine entsprechend dicke Ausgestaltung ermöglicht die Haftklebemasse 5 zudem die Beabstandung der Abdeckung 4 von der elektronischen Struktur 3.

Bei der Haftklebemasse 5 handelt es sich um eine solche auf Basis der erfindungsgemäßen Haftklebemasse wie sie vorstehend in allgemeiner Form beschrieben wurde und nachfolgend in Ausführungsbeispielen näher dargelegt ist. Die Haftklebemasse 5 übernimmt vorliegend nicht nur die Funktion des Verbindens des Substrats 2 mit der Abdeckung 4 sondern bildet zudem auch eine Barriereschicht für Permeanten bereit, um so die elektronische Struktur 2 auch von der Seite gegen Permeanten wie Wasserdampf und Sauerstoff zu kapseln.

Die Haftklebemasse 5 wird vorliegend zudem in Form eines Stanzlings aus einem doppelseitigen Klebebandes bereitgestellt. Ein derartiger Stanzling ermöglicht eine besonders einfache Applikation.

Fig. 2 zeigt eine alternative Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun die Haftklebemasse 5 vollflächig angeordnet. Die elektronische Struktur 3 wird somit von oben vollständig durch die Haftklebemasse 5 gekapselt. Auf die Haftklebemasse 5 ist sodann eine Abdeckung 4 aufgebracht. Diese Abdeckung 4 muss im Gegensatz zu der vorherigen Ausgestaltung nicht zwingend die hohen Barriereanforderungen erfüllen, da die Barriere bereits durch die Haftklebemasse bereitgestellt wird. Die Abdeckung 4 kann beispielsweise lediglich eine mechanische Schutzfunktion wahrnehmen, sie kann aber auch zusätzlich als Permeationsbarriere vorgesehen sein.

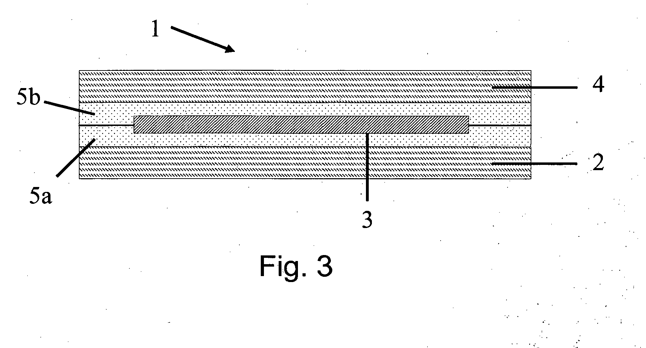

Fig. 3 zeigt eine weitere alternative Ausgestaltung einer (opto-)elektronischen Anordnung 1. Im Gegensatz zu den vorherigen Ausgestaltungen sind nun zwei Haftklebemassen 5a, b vorgesehen, die vorliegend identisch ausgebildet sind. Die erste Haftklebemasse 5a ist vollflächig auf dem Substrat 2 angeordnet. Auf der Haftklebemasse 5a ist die elektronische Struktur 3 vorgesehen, die durch die Haftklebemasse 5a fixiert wird. Der Verbund aus Haftklebemasse 5a und elektronischer Struktur 3 wird dann mit der weiteren Haftklebemasse 5b vollflächig überdeckt, so dass die elektronische Struktur 3 von allen Seiten durch die Haftklebemassen 5a, b gekapselt ist. Oberhalb der Haftklebemasse 5b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeanten zur elektronischen Struktur 3 weiter einzuschränken.

Insbesondere im Hinblick auf die Fig. 2, 3 wird darauf hingewiesen, dass es sich vorliegend um schematische Darstellungen handelt. Aus den Darstellungen ist insbesondere nicht ersichtlich, dass die Haftklebemasse 5 hier und vorzugsweise jeweils mit einer homogenen Schichtdicke aufgetragen wird. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Ggf. kann jedoch auch eine Anpassung an den Untergrund erfolgen, insbesondere dann, wenn die Applikation unter Vakuum durchgeführt wird. Zudem wird die Haftklebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Die Applikation der Haftklebemasse 5 erfolgt in allen gezeigten Ausführungsbeispielen in Form eines Haftklebebandes. Dabei kann es sich grundsätzlich um ein doppelseitiges Haftklebeband mit einem Träger oder um ein Transferklebeband handeln. Vorliegend ist eine Ausgestaltung als Transferklebeband gewählt.

Die Dicke der Haftklebemasse, die entweder als Transferklebeband oder auf einem flächigen Gebilde beschichtet vorliegt, beträgt bevorzugt zwischen etwa 1 µm und etwa 150 µm, weiter bevorzugt zwischen etwa 5 µm und etwa 75 µm und besonders bevorzugt zwischen etwa 12 µm und 50 µm. Hohe Schichtdicken zwischen 50 µm und 150 µm werden dann eingesetzt wenn eine verbesserte Haftung auf dem Substrat und/oder eine dämpfende Wirkung innerhalb des (opto-) elektronischen Aufbaus erreicht werden soll. Nachteilig ist hier jedoch der erhöhte Permeationsquerschnitt. Geringe Schichtdicken zwischen 1 µm und 12 µm reduzieren den Permeationsquerschnitt, damit die laterale Permeation und die Gesamtdicke des (opto-) elektronischen Aufbaus. Jedoch kommt es zu einer Verringerung der Haftung aus dem Substrat. In den besonders bevorzugten Dickenbereichen liegt ein guter Kompromiss zwischen einer geringen Massendicke und dem daraus folgenden niedrigen Permeationsquerschnitt, der die laterale Permeation verringert, und einem genügend dicken Massefilm zur Herstellung einer ausreichend haftenden Verbindung. Die optimale Dicke hängt vom (opto-)elektronischen Aufbau, der Endanwendung, der Art der Ausführung der Haftklebemasse und gegebenenfalls dem flächigen Substrat ab.

### Beispiele

Sofern nicht anders angegeben, sind alle Mengenangaben in den nachfolgenden Beispielen Gewichtsprozente bzw. Gewichtsteile bezogen auf die Gesamtzusammensetzung.

### Prüfmethoden

### Klebkraft

Die Bestimmung der Klebkraft wurde wie folgt durchgeführt: Als definierter Haftgrund wurde eine Stahlfläche, eine Polyethylenterephthalat- (PET) und eine Polyethylen-Platte (PE) eingesetzt. Das zu untersuchende verklebbare Flächenelement wurde auf eine Breite von 20 mm und eine Länge von etwa 25 cm zugeschnitten, mit einem Handhabungsabschnitt versehen und unmittelbar danach fünfmal mit einer Stahlrolle von 4 kg bei einem Vorschub von 10 m/min auf den jeweils gewählten Haftgrund aufgedrückt. Unmittelbar im Anschluss daran wurde das zuvor verklebte Flächenelement in einem Winkel von 180° bei Raumtemperatur und mit 300 mm/min vom Haftgrund mit einem Zugprüfungsgerät (Firma Zwick) abgezogen und die hierfür benötigte Kraft gemessen. Der Messwert (in N/cm) ergab sich als Mittelwert aus drei Einzelmessungen.

### Scherstandzeit

Die Bestimmung der Scherstandzeiten (SSZ) wurde wie folgt durchgeführt: Als definierter Haftgrund wurde eine polierte Stahlfläche eingesetzt. Das zu untersuchende verklebbare Flächenelement wurde auf eine Breite von 13 mm und eine Länge von etwa 5 cm zugeschnitten und unmittelbar danach viermal mit einer Stahlrolle von 2 kg bei einem Vorschub von 10 m/min auf den jeweils gewählten Haftgrund mit einer Fläche von 20 x 13 mm² aufgedrückt. Unmittelbar im Anschluss daran wurde das verklebbare Flächenelement in einem Winkel von 180° mit 10 N bei 23°C / 50% RH belastet. Gemessen wird die Zeit, nach der sich das verklebbare Flächenelement vollständig vom Haftgrund gelöst hat. Der Messwert (in min) ergibt sich als Median aus drei Einzelmessungen. Nach 10.000 Minuten wird der Test abgebrochen.

### Elastischer Anteil

Die Bestimmung des elastischen Anteils wurde wie folgt durchgeführt: Als definierter Haftgrund wurde eine polierte Stahlfläche eingesetzt. Das zu untersuchende verklebbare Flächenelement wurde auf eine Breite von 10 mm und eine Länge von etwa 5 cm zugeschnitten und unmittelbar danach dreimal mit einer Stahlrolle von 2 kg bei einem Vorschub von 10 m/min auf den jeweils gewählten Haftgrund mit einer Fläche von 10 x 13 mm aufgedrückt. Unmittelbar im Anschluss daran wurde das verklebbare Flächenelement in einem Winkel von 180° mit 1 N und mit 5 N, bei einer Temperatur von 40°C belastet. Gemessen wird die Rutschtrecke nach 15 Minuten, dann wird die Probe entlastet und die Rutschstrecke nach insgesamt 30 Minuten bestimmt. Das Verhältnis der beiden Messwerte ist ein Maß für elastische und viskose Anteile der Klebemasse. Die Messwerte ergeben sich als Mittelwert aus zwei Einzelmessungen.

### Transmission

Die Transmission der Klebemasse wurde über das VIS-Spektrum bestimmt. Die Aufnahmen des VIS-Spektrums wurden an einem UVIKON 923 der Firma Kontron durchgeführt. Der Wellenlängenbereich des gemessenen Spektrums umfasst alle Frequenzen zwischen 800 nm und 400 nm bei einer Auflösung von 1 nm. Dazu wurde die Klebemasse auf einen PET-Träger aufgebracht und vor der Messung wurde eine Leerkanalmessung des Trägers als Referenz über den gesamten Wellenlängenbereich durchgeführt. Für die Angabe des Ergebnisses wurden die Transmissionsmessungen im angegebenen Bereich gemittelt.

### Permeation

Die Bestimmung der Permeabilität für Sauerstoff (OTR) und Wasserdampf (WVTR) erfolgte nach DIN 53380 Teil 3 bzw. ASTM F-1249. Die Haftklebemasse wurde dazu mit einer Schichtdicke von 50 µm auf eine permeable Membran aufgebracht. Für die Sauerstoffdurchlässigkeit wurde bei 23°C und einer relativen Feuchte von 50 % gemessen mit einem Messgerät Mocon OX-Tran 2/21. Die Wasserdampfdurchlässigkeit wurde bei 37,5°C und einer relativen Feuchte von 90 % bestimmt.

### Biegetest

Für die Bestimmung der Flexibilität wurde die Klebemasse in einer Schichtdicke von 50 µm zwischen zwei 23 µm PET-Trägern beschichtet und auf einen Biegeradius von 1 mm bei einer Biegung von 180° geprüft. Bestanden ist der Test, falls es nicht zum Bruch oder Ablösen der Schicht kommt.

### Lebensdauertest

Als ein Maß für die Bestimmung der Lebensdauer eines (opto-)elektronischen Aufbaus wurde ein Calciumtest herangezogen. Dazu wird unter Stickstoffatmosphäre eine 20 x 20 mm² große, dünne Calciumschicht auf eine Glasplatte abgeschieden. Die Dicke der Calciumschicht liegt bei etwa 100 nm. Für die Verkapselung der Calciumschicht wird ein Klebeband mit einer PET-Barrierefolie als Trägermaterial verwendet (WVTR = 8x10⁻² g/m²*d und OTR = 6x10⁻² cm3/m²*d*bar, entsprechend nach ASTM F-1249 und DIN 53380 Teil 3 und oben genannten Bedingungen). Das Klebeband wird mit einem allseitigen Rand von 5 mm über dem Calciumspiegel appliziert, in dem es direkt auf der Glasplatte haftet.

Der Test basiert auf der Reaktion von Calcium mit Wasserdampf und Sauerstoff, wie sie beispielsweise von A.G. Erlat et. al. in "47th Annual Technical Conference Proceedings - Society of Vacuum Coaters", 2004, Seiten 654-659, und von M. E. Gross et al. in "46th Annual Technical Conference Proceedings - Society of Vacuum Coaters", 2003, Seiten 89-92, beschrieben sind. Dabei wird die Lichttransmission der Calciumschicht überwacht, welche durch die Umwandlung in Calciumhydroxid und Calciumoxid zunimmt. Das Erreichen von 90 % der Transmission des Aufbaus ohne Calciumschicht wird als Ende der Lebensdauer bezeichnet. Als Messbedingungen werden 23°C und 50 % relative Luftfeuchte gewählt. Die Muster wurden mit einer Schichtdicke der Haftklebmasse von 25 µm vollflächig und blasenfrei verklebt.

### Bestimmung des VOC-Wertes (volatile organic compounds)

Die Bestimmung des VOC-Wertes erfolgt nach VDA 277. Mit dieser Methode wird die Summe der gasförmigen (leichtflüchtigen) Kohlenwasserstoffe (VOC - Volative Organic Components) aus geringen Probenmengen im Labormaßstab bestimmt. Es wird dabei eine Probe (<1g) in ein Glasgefäß (10 ml) 5 Stunden bei 120°C konditioniert. Eine definierte Menge des Gasraumes aus dem gasdichten Gefäß wird anschließend mittels der Kombination Gaschromatograph (GC) / Flammenionisationsdetektor (FID) auf die darin enthaltenen Kohlenwasserstoffe untersucht.

*Bestimmung der Obenflächenleitfähigkeit von ITO bei Kontakt mit den Haftklebemassen* Eine ITO-beschichtete PET-Folie mit den Maßen 2 x 2 cm² und einem Oberflächenwiderstand von 200 Ohm wird an den Enden kontaktiert. In einem Abstand von 0,5 cm von den kontaktierten Enden wir ein Klebestreifen der Breite 1 cm vollflächig aufgebracht. Die Probe wird bei 60°C und 90 % Luftfeuchte gelagert und der Widerstand nach 14 Tagen bestimmt.

### Herstellung der Muster

Die Haftklebemassen in Beispiel 1 bis 4 wurden aus Lösung hergestellt. Dazu wurden die einzelnen Bestandteile in Toluol gelöst (Feststoffanteil 40%), auf eine unbehandelte PET-Folie beschichtet und bei 120°C 15 Minuten lang getrocknet, so dass eine Klebmasseschicht mit einem Flächengewicht von 50 g/m² entstand. Für den Permeationstest wurden Muster in gleicher Weise erstellt, jedoch erfolgte die Beschichtung nicht auf eine PET-Folie sondern auf ein mit 1,5 g/m² silikonisiertes Trennpapier, so dass nach dem Transfer auf die permeable Membran eine Messung an der puren Haftklebemasse vorgenommen werden konnte.

### Beispiel 1

| | | |
|---|---|---|
| 100 Teile | SiBStar 103T | Triblock-SiBS mit 30 % Blockpolystyrolgehalt der Firma Kaneka |
| 40 Teile | SiBStar 042D | Diblock-SiB mit 15 % Blockpolystyrolgehalt der Firma Kaneka |
| 120 Teile | Escorez 5600 | Hydriertes KW-Harz mit einem Erweichungspunkt von 100°C der Firma Exxon |

### Beispiel 2

| | | |
|---|---|---|
| 120 Teile | Oppanol IBS | Triblock-SiBS von BASF |
| 20 Teile | SiBStar 042D | Diblock-SiB mit 15 % Blockpolystyrolgehalt der Firma Kaneka |
| 80 Teile | Escorez 5600 | Hydriertes KW-Harz mit einem Erweichungspunkt von 100°C der Firma Exxon |
| 25 Teile | Ondina G 17 | Weißöl aus parafinischen und naphtenischen Anteilen der Firma Shell |

### Beispiel 3

| | | |
|---|---|---|
| 20 Teile | Tuftec P 1500 | SBBS mit 30 % Blockpolystyrolgehalt und ca. 68% Zweiblockgehalt der Firma Asahi |
| 100 Teile | SiBStar 103T | Triblock-SiBS mit 30 % Blockpolystyrolgehalt der Firma Kaneka |
| 20 Teile | SiBStar 042D | Diblock-SiB mit 15 % Blockpolystyrolgehalt der Firma Kaneka |
| 100 Teile | Escorez 5600 | Hydriertes KW-Harz mit einem Erweichungspunkt von 100°C der Firma Exxon |
| 25 Teile | Ondina G 17 | Weißöl aus parafinischen und naphtenischen Anteilen der Firma Shell |

### Vergleichsbeispiel V0

| | | |
|---|---|---|
| 100 Teile | Oppanol B10 | Polyisobutylen mit einem mittleren Molekulargewicht von 40.000 g/mol |
| 70 Teile | Oppanol B150 | Polyisobutylen mit einem mittleren Molekulargewicht von > 800.000 g/mol |
| 100 Teile | Escorez 5600 | Hydriertes KW-Harz mit einem Erweichungspunkt von 100°C der Firma Exxon |

### Vergleichsbeispiel V1

| | | |
|---|---|---|
| 70 Teile | Tuftec P 1500 | SBBS mit 30 % Blockpolystyrolgehalt der Firma Asahi Das SBBS enthielt ca. 68% Zweiblockgehalt. |
| 30 Teile | Kraton G 1657 | SEBS mit 13 % Blockpolystyrolgehalt der Firma Kraton Das SEBS enthielt ca. 36% Zweiblockgehalt. |
| 100 Teile | Escorez 5600 | Hydriertes KW-Harz mit einem Erweichungspunkt von 100°C der Firma Exxon |
| 25 Teile | Ondina G 17 | Weißöl aus parafinischen und naphtenischen Anteilen der Firma Shell |

### Vergleichsbeispiel V2

| | | |
|---|---|---|
| 100 Teile | Kraton G 1657 | SEBS mit 13 % Blockpolystyrolgehalt der Firma Kraton Das SEBS enthielt ca. 36% Zweiblockgehalt. |
| 100 Teile | Escorez 5600 | Hydriertes KW-Harz mit einem Erweichungspunkt von 100°C der Firma Exxon |
| 25 Teile | Ondina G 17 | Weißöl aus parafinischen und naphtenischen Anteilen der Firma Shell |

### Vergleichsbeispiel V3

Es wurde ein Acrylat mit der Zusammensetzung 78% EHA, 19% Stearylacrylat und 3% Acrylsäure in Aceton und Benzin polymerisiert und aus der Lösung auf einen unbehandelten PET-Träger (bzw. für die Permeationsmessungen auf ein mit 1,5 g/m² silikonisiertes Trennpapier) beschichtet, bei 120°C für 15 min getrocknet und mit 0,2% Aluminiumchelat, bezogen auf den Anteil Polymer vernetzt. Die Dicke der Klebeschicht beträgt 50 µm.

### Vergleichsbeispiel V4

Eine Mischung aus 60% Levamelt 456 (Etylen-Vinylacetat) und 40% Foral FG85 werden in Aceton gelöst und aus der Lösung auf einen unbehandelten PET-Träger (bzw. für die Permeationsmessungen auf ein mit 1,5 g/m² silikonisiertes Trennpapier) beschichtet und bei 120°C für 15 min getrocknet. Die Dicke der Klebeschicht beträgt 50 µm.

### Vergleichsbeispiel V5

Die kommerziell erhältliche Silikonhaftklebemasse Silgrip PSA529 von GE Bayer Silikons wird mit Benzoylperoxid abgemischt und aus der Lösung auf einen unbehandelten PET-Träger (bzw. für die Permeationsmessungen auf ein mit 1,5 g/m² fluorsilikonisiertes Trennpapier) beschichtet und bei 120°C für 15 min getrocknet und vernetzt. Die Dicke der Klebeschicht beträgt 50 µm.

### Vergleichsbeispiel V6

Ein kommerziell erhältliches UV-härtendes Epoxid von Epo-Tek OG142 wurde auf eine PET-Folien in einer Dicke von 50 µm ausgestrichen und mit 160 W/cm mit einer Mitteldruck - Quecksilberdampflampe bei einer Bahngeschwindigkeit von 10 m/min ausgehärtet. Für die Bestimmung der Permeation wurde das Muster auf silikonisiertes Trennpapier beschichtet und abgezogen.

### Ergebnisse:

Zur klebtechnischen Beurteilung der oben genannten Beispiele wurden zunächst die Klebkraft, die Scherstandzeiten (SSZ), elastischer Anteil und der Test auf Flexibilität durchgeführt.

**Tabelle 1**

| | Klebkraft [N/cm] Stahl / PET/ PE | elastischer Anteil [%] | SSZ [min] | Biegetest |
|---|---|---|---|---|
| Beispiel 1 | 5,5 / 4,9 / 4,2 | 42 | 10.000 | bestanden |
| Beispiel 2 | 4,5 / 4,3 / 3,5 | 47 | 10.000 | bestanden |
| Beispiel 3 | 6,7 / 6,3 / 5,6 | 39 | 10.000 | bestanden |
| V0 | 7,5 / 7,0 / 4,9 | 10 | 50 | bestanden |
| V1 | 6,6 / 6,3 / 5,7 | 48 | 10.000 | bestanden |
| V2 | 4,2 / 3,9 / 3,6 | 42 | 10.000 | bestanden |
| V3 | 9,5 / 5,5 / 4,2 | 38 | 7250 | bestanden |
| V4 | 5,5 / 3,5 / 0,9 | 12 | 3200 | bestanden |
| V5 | 5,5 / 5,7 / 3,9 | 40 | 10.000 | bestanden |
| V6 | - | - | - | nicht bestanden |

Die Beispiele 1 bis 3 zeigen eine gute Klebkraft bei hohen Scherfestigkeiten. Die Klebkräfte bei Beispiel 3 sind durch die Zugabe eines teilhydrierten Vinylaromatenblockcopolymers (SBBS) zum Isobutylenblockcopolymer als Bestandteil der Haftklebemasse erhöht worden. Die Permeabilität erhöht sich jedoch leicht. Das Vergleichbeispiel V1 zeigt eine Haftklebemasse auf Basis eines SBBS Blockcopolymers. Die klebtechnischen Eigenschaften sind denen von Beispiel 3 sehr ähnlich, jedoch ist die Barrierewirkung schlechter.

Die unvernetzte PiB Haftklebemasse V0 zeigt einen sehr viel geringeren elastischen Anteil. Insbesondere bei der dauerhaften Scherbelastung (SSZ) zeigt sich die Kriechneigung der polyisiobutylenbasierten Haftklebemasse. Bereits nach einer sehr kurzen Belastungsdauer kommt es zu einem kohäsiven Versagen. Durch die physikalische Vernetzung über die Styroldomänen bei den styrolisobutylenbasierten Massen wird diese Kriechneigung bei Raumtemperatur unterbunden.

Die Bestimmung der Flexibilität zeigt, dass Haftklebemassen eine höhere Flexibilität bieten als hochvernetzte Epoxide.

Die Ergebnisse der Permeations- und Transmissionsmessungen sind in Tabelle 2 gezeigt.

**Tabelle 2**

| | WVTR g / (m²*Tag) | OTR g / (m²*Tag*bar) | Transmission [%] |
|---|---|---|---|
| Beispiel 1 | 8 | 2.100 | 89 |
| Beispiel 2 | 12 | 2.400 | 88 |
| Beispiel 3 | 25 | 6.280 | 89 |
| V0 | 11 | 2.600 | 90 |
| V1 | 53 | 6.900 | 87 |
| V2 | 89 | 7280 | 88 |
| V3 | 320 | 40.250 | 90 |
| V4 | > 1.000 | 62.000 | 92 |
| V5 | > 1.000 | 75.000 | 93 |
| V6 | 27 | 35 | 93 |

Wie der Tabelle 2 zu entnehmen ist, ist die Permeabilität der erfindungsgemäßen Haftklebemassen in den Beispielen 1 bis 3 im Vergleich zu V1 bis V4 sehr viel geringer während die Transmission im sichtbaren Bereich des Lichts ähnlich ist. Die Wasserdampfpermeabilität des vernetzten Epoxides und der Blockcopolymere ist ähnlich, die Sauerstoffdurchlässigkeit liegt höher. Die Transmission liegt für alle Beispiele in einem ähnlichen Bereich.

Ergebnisse des Lebensdauertests:

| | Lebensdauer [t/h] |
|---|---|
| | |
| Beispiel 1 | 385 |
| Beispiel 2 | 375 |
| Beispiel 3 | 360 |
| V0 | 365 |
| V1 | 310 |
| V2 | 260 |
| V3 | 29 |
| V4 | 11 |

Die Lebensdauertests zeigen im Vergleich zu anderen Haftklebemassen deutlich, die sehr viel bessere Barrierewirkung und die daraus resultierende Verlängerung der Lebensdauer des Messaufbaus. Die Haftklebemasse auf Basis von Polyisobutylen zeigt ähnlich gute Werte für die Lebensdauer, jedoch bei sehr viel geringerer Scherfestigkeit.

### Ergebnisse der VOC-Messungen

| | VOC [µgC/g] | Oberflächenwiderstand [Ohm/sq] |
|---|---|---|
| | | |
| Beispiel 1 | 5 | 220 |
| Beispiel 2 | 4 | 230 |
| Beispiel 3 | 6 | 227 |
| V3 | 120 | 310 |
| V3-1 | 320 | 380 |
| V3-2 | 2800 | 1600 |
| V4 | 520 | 1450 |

Massen auf Basis der hier beschrieben Haftklebemassen zeigen insbesondere im Vergleich zu Acrylaten bei vergleichbaren Trocknungsparamtern sehr geringe VOC-Werte. Diese Wirken sich positiv auf die Lebensdauer und Leistung von Ito-Schichten in (opto) elektronischen Aufbauten aus.

## Patentansprüche

1. Verfahren zur Kapselung einer elektronischen Anordnung gegen Permeanten,
bei dem eine Haftklebmasse auf Basis von Butylenblockcopolymeren, insbesondere isobutylenblockcopolymeren, bereitgestellt wird und
bei dem die Haftklebemasse auf und/oder um die zu kapselnden Bereiche der elektronischen Anordnung appliziert wird,
wobei der maximale Anteil der Blockcopolymere in Summe bezogen auf die gesamte Haftklebmasse maximal 70 Gew.-% beträgt
und wobei die Dicke der Haftklebemasse zwischen 1 µm und 150 µm liegt.

2. Verfahren nach Anspruch 1, **dadurch gekennzeichnet,**
**dass** die Haftklebemasse in Form eines Klebebandes bereitgestellt wird.

3. Verfahren nach Anspruch 1 oder 2, **dadurch gekennzeichnet,**
**dass** die Haftklebemasse und/oder die zu kapselnden Bereiche der elektronischen Anordnung vor, während und/oder nach der Applikation der Haftklebemasse erwärmt werden.

4. Verfahren nach einem der vorhergehenden Ansprüche, **dadurch gekennzeichnet,**
**dass** die Haftklebemasse nach der Applikation auf der elektronischen Anordnung vernetzt wird.

5. Verfahren nach einem der vorhergehenden Ansprüche, **dadurch gekennzeichnet,**
**dass** die Applikation der Haftklebemasse ohne anschließendes Aushärten erfolgt.

6. Verwendung einer Haftklebmasse zur Kapselung einer elektronischen Anordnung gegen Permeanten, insbesondere in einem Verfahren nach einem der vorhergehenden Ansprüche,
**dadurch gekennzeichnet,**
**dass** die Haftklebmasse auf Butylenblockcopolymeren, insbesondere isobutylenblockcopolymeren, basiert,
wobei der maximale Anteil der Blockcopolymere in Summe bezogen auf die gesamte Haftklebmasse maximal 70 Gew.-% beträgt
und wobei die Dicke der Haftklebemasse zwischen 1 µm und 150 µm liegt.

7. Verwendung nach Anspruch 6, **dadurch gekennzeichnet,**
**dass** die Haftklebemasse Polymerblöcke gebildet aus Vinylaromaten, insbesondere Styrol, enthält, und
**dass** die Haftklebemasse Polymerblöcke gebildet durch Polymerisation von Isobutylen oder von Isobutylen in Kombination mit n-Buten und/oder 1,3-Dienen insbesondere Butadien und/oder Isopren, enthält,

8. Verwendung nach Anspruch 6 oder 7, **dadurch gekennzeichnet,**
**dass** die Blockcopolymere einen Polyvinylaromatenanteil von 10 Gew.-% bis 35 Gew.-% aufweisen.

9. Verwendung nach einem der Ansprüche 6 bis B, **dadurch gekennzeichnet,**
**dass** die Haftklebemasse einen Anteil der Blockcopolymere von mindestens 20 Gew.-%, vorzugsweise von mindestens 30 Gew.-%, weiter bevorzugt von mindestens 35 Gew.-%, aufweist.

10. Verwendung nach einem der Ansprüche 6 bis 9, **dadurch gekennzeichnet,**
**dass** der Anteil der Isobutylenblockeopolymere am Gesamtanteil der Blockcopolymere mindestens 40 Gew.-%, vorzugsweise mindestens 55 Gew.-% beträgt.

11. Verwendung nach einem der Ansprüche 6 bis 10, **dadurch gekennzeichnet,**
**dass** die Haftklebemasse einen Harz oder ein Harzgemisch enthält,
vorzugsweise hydrierte Harze mit einem Hydrierungsgrad von mindestens 90%, weiter bevorzugt von mindestens 95%.

12. Verwendung nach einem der Ansprüche 6 bis 11, **dadurch gekennzeichnet,**
**dass** die Haftklebemasse zumindest ein Harz enthält, das einen DACP-Wert von mehr als 30 °C und einen MMAP-Wert von mehr als 50 °C aufweist, vorzugsweise einen DACP-Wert von mehr als 37 °C und einen MMAP-Wert von mehr als 60 °C, und/oder
**dass** die Haftklebemasse zumindest ein Harz enthält, das eine
Erweichungstemperatur von mehr als 95 °C, insbesondere von mehr als 100°C aufweist.

13. Verwendung nach einem der Ansprüche 6 bis 12, **dadurch gekennzeichnet,**
**dass** die Haftklebemasse ein oder mehrere Additive enthält,
vorzugsweise ausgewählt aus der Gruppe bestehend aus: Plastifizierungsmitteln, primären Antioxidanzien, sekundären Antioxidanzien, Prozessstabilisatoren, Lichtschutzmitteln, Verarbeitungshilfsmittel, Endblockverstärkerharzen, Polymeren,
insbesondere elastomerer Natur.

14. Verwendung nach einem der Ansprüche 6 bis 13, **dadurch gekennzeichnet,**
**dass** die Haftklebemasse einen oder mehrere Füllstoffe enthält,
vorzugsweise nanoskalige Füllstoffe, transparente Füllstoffe und/oder Getter- und/oder Scavenger-Füllstoffe.

15. Verwendung nach einem der Ansprüche 6 bis 14, **dadurch gekennzeichnet,**
**dass** die Haftklebemasse transparent ausgebildet ist,
vorzugsweise, dass die Haftklebemasse im Wellenlängenbereich von 400 nm bis 800 nm einem mittleren Transmissionsgrad von mindestens 75%, weiter bevorzugt von mindestens 90%, aufweist.

16. Verwendung nach einem der Ansprüche 6 bis 15, **dadurch gekennzeichnet,**
**dass** die Haftklebemasse UV-blockend im Wellenlängenbereich von 320 nm bis 400 nm ausgebildet ist, vorzugsweise im Wellenlängenbereich von 280 nm bis 400 nm, weiter vorzugsweise im Wellenlängenbereich von 190 nm bis 400 nm, wobei als UV-blockend ein mittlerer Transmissionsgrad von maximal 20%, vorzugsweise von maximal 10%, weiter bevorzugt von maximal 1% bezeichnet wird.

17. Verwendung nach einem der Ansprüche 6 bis 16, **dadurch gekennzeichnet,**
**dass** die Haftklebemasse eine WVTR kleiner 40 g/m²·d, vorzugsweise kleiner 10 g/m²·d, ganz bevorzugt kleiner 1 g/m²·d, aufweist und/oder dass die Haftklebemasse eine OTR kleiner 5000 g/m²·d·bar, vorzugsweise kleiner 3000 g/m²·d·bar, aufweist

18. Verwendung nach einem der Ansprüche 6 bis 17, **dadurch gekennzeichnet,**
**dass** die Haftklebemasse als Klebeband, insbesondere als trägerfreies Klebeband, ausgebildet ist.

19. Elektronische Anordnung mit einer elektronischen Struktur, insbesondere einer organischen elektronischen Struktur, und einer Haftklebemasse,
wobei die elektronische Struktur zumindest teilweise durch die Haftklebmasse gekapselt ist,
**dadurch gekennzeichnet,**
**dass** die Haftklebemasse gemäß einem der Ansprüche 6 bis 18 ausgebildet ist.

## Claims

1. Method of encapsulating an electronic arrangement with respect to permeants,
in which a pressure-sensitive adhesive based on butylene block copolymers, in particular isobutylene block copolymers, is provided and
in which the pressure-sensitive adhesive is applied to and/or around the regions of the electronic arrangement that are to be encapsulated,
wherein the maximum fraction of the block copolymers in total, based on the overall pressure-sensitive adhesive, is not more than 70% by weight and wherein the thickness of the pressure-sensitive adhesive is between 1 µm and 150 µm.

2. Method according to Claim 1, **characterized in that**
the pressure-sensitive adhesive is provided in the form of an adhesive tape.

3. Method according to Claim 1 or 2, **characterized in that**
the pressure-sensitive adhesive and/or the regions of the electronic arrangement that are to be encapsulated are heated before, during and/or after the application of the pressure-sensitive adhesive.

4. Method according to any of the preceding claims, **characterized in that**
the pressure-sensitive adhesive is crosslinked following application on the electronic arrangement.

5. Method according to any of the preceding claims, **characterized in that**
the application of the pressure-sensitive adhesive takes place without subsequent curing.

6. Use of a pressure-sensitive adhesive for encapsulating an electronic arrangement with respect to permeants, more particularly in a method according to any of the preceding claims,
**characterized in that**
the pressure-sensitive adhesive is based on butylene block copolymers, in particular isobutylene block copolymers,
wherein the maximum fraction of the block copolymers in total, based on the overall pressure-sensitive adhesive, is not more than 70% by weight and wherein the thickness of the pressure-sensitive adhesive is between 1 µm and 150 µm.

7. Use according to Claim 6, **characterized in that** the pressure-sensitive adhesive comprises polymer blocks formed from vinylaromatics, more particularly styrene, and
**in that** the pressure-sensitive adhesive comprises polymer blocks formed by polymerization of isobutylene or isobutylene in combination with n-butene and/or 1,3-dienes, more particularly butadiene and/or isoprene,
and/or specifically or fully hydrogenated polymer blocks.

8. Use according to Claim 6 or 7, **characterized in that**
the block copolymers have a polyvinylaromatic fraction of 10% to 35% by weight.

9. Use according to any of Claims 6 to 8, **characterized in that**
the pressure-sensitive adhesive has a block copolymer fraction of at least 20%, preferably of at least 30%, more preferably of at least 35%, by weight.

10. Use according to any of Claims 6 to 9, **characterized in that**
the fraction of the isobutylene block copolymers as a proportion of the total fraction of the block copolymers is at least 40% by weight, preferably at least 55% by weight.

11. Use according to any of Claims 6 to 10, **characterized in that**
the pressure-sensitive adhesive comprises a resin or a resin mixture,
preferably hydrogenated resins having a degree of hydrogenation of at least 90%, more preferably of at least 95%.

12. Use according to any of Claims 6 to 11, **characterized in that**
the pressure-sensitive adhesive comprises at least one resin which has a DACP value of more than 30°C and an MMAP value of more than 50°C, preferably a DACP value of more than 37 °C and an MMAP value of more than 60°C, and/or
**in that** the pressure sensitive adhesive comprises at least one resin which has a softening temperature of more than 95°C, more particularly of more than 100°C.

13. Use according to any of Claims 6 to 12, **characterized in that**
the pressure-sensitive adhesive comprises one or more additives,
preferably selected from the group consisting of: plasticizers, primary antioxidants, secondary antioxidants, in-process stabilizers, light stabilizers, processing assistants, endblock reinforcer resins, polymers, especially elastomeric in nature.

14. Use according to any of Claims 6 to 13, **characterized in that**
the pressure-sensitive adhesive comprises one or more fillers,
preferably nanoscale fillers, transparent fillers and/or getter and/or scavenger fillers.

15. Use according to any of Claims 6 to 14, **characterized in that**
the pressure-sensitive adhesive is transparent in form, preferably **in that** the pressure-sensitive adhesive has an average transmittance of at least 75%, more preferably of at least 90%, in the wavelength range from 400 nm to 800 nm.

16. Use according to any of Claims 6 to 15, **characterized in that**
the pressure-sensitive adhesive is of UV-blocking design in the wavelength range from 320 nm to 400 nm, preferably in the wavelength range from 280 nm to 400 nm, more preferably in the wavelength range from 190 nm to 400 nm,
UV-blocking denoting an average transmittance of not more than 20%, preferably of not more than 10%, more preferably of not more than 1%.

17. Use according to any of Claims 6 to 16, **characterized in that**
the pressure-sensitive adhesive has a WVTR of less than 40 g/m²·d, preferably less than 10 g/m²·d, more preferably less than 1 g/m²·d, and/or
**in that** the pressure-sensitive adhesive has an OTR of less than 5000 g/m²·d·bar, preferably less than 3000 g/m²·d·bar.

18. Use according to any of Claims 6 to 17, **characterized in that**
the pressure-sensitive adhesive is in the form of an adhesive tape, more particularly a carrier-free adhesive tape.

19. Electronic arrangement having an electronic structure, more particularly an organic electronic structure, and a pressure-sensitive adhesive,
the electronic structure being at least partly encapsulated by the pressure-sensitive adhesive, **characterized in that**
the pressure-sensitive adhesive is of a form according to any of Claims 6 to 18.

## Revendications

1. Procédé d'encapsulation d'un dispositif électronique contre des produits de perméation, dans lequel une masse autoadhésive à base de copolymères à blocs de butylène, en particulier à base de copolymères à blocs d'isobutylène, est mise à disposition et dans lequel la masse autoadhésive est appliquée sur et/ou autour des zones à encapsuler du dispositif électronique, la proportion maximale des copolymères à blocs, au total, par rapport à la masse autoadhésive totale est d'au maximum 70% en poids et l'épaisseur de la masse autoadhésive se situant entre 1 µm et 150 µm.

2. Procédé selon la revendication 1, **caractérisé en ce que** la masse autoadhésive est mise à disposition sous forme d'une bande adhésive.

3. Procédé selon la revendication 1 ou 2, **caractérisé en ce que** la masse autoadhésive et/ou les zones à encapsuler du dispositif électronique est/sont chauffée(s) avant, pendant et/ou après l'application de la masse autoadhésive.

4. Procédé selon l'une quelconque des revendications précédentes, **caractérisé en ce que** la masse autoadhésive est réticulée après l'application sur le dispositif électronique.

5. Procédé selon l'une quelconque des revendications précédentes, **caractérisé en ce que** l'application de la masse autoadhésive s'effectue sans durcissement consécutif.

6. Utilisation d'une masse autoadhésive pour l'encapsulation d'un dispositif électronique contre des produits de perméation, en particulier dans un procédé selon l'une quelconque des revendications précédentes, **caractérisée en ce que** la masse autoadhésive est à base de copolymères à blocs de butylène, en particulier à base de copolymères à blocs d'isobutylène,
la proportion maximale des copolymères à blocs, au total, par rapport à la masse autoadhésive totale étant d'au maximum 70% en poids et l'épaisseur de la masse autoadhésive se situant entre 1 µm et 150 µm.

7. Utilisation selon la revendication 6, **caractérisée en ce que** la masse autoadhésive contient des blocs polymères formés à partir d'aromatiques de vinyle, en particulier de styrène, et **en ce que** la masse autoadhésive contient des blocs polymères formés par polymérisation d'isobutylène ou d'isobutylène en combinaison avec du n-butène et/ou des 1,3-diènes, en particulier du butadiène et/ou de l'isoprène.

8. Utilisation selon la revendication 6 ou 7, **caractérisée en ce que** les copolymères à blocs présentent une proportion de poly(aromatique de vinyle) de 10% en poids à 35% en poids.

9. Utilisation selon l'une quelconque des revendications 6 à 8, **caractérisée en ce que** la masse autoadhésive présente une proportion de copolymères à blocs d'au moins 20% en poids, de préférence d'au moins 30% en poids, plus préférablement d'au moins 35% en poids.

10. Utilisation selon l'une quelconque des revendications 6 à 9, **caractérisée en ce que** la proportion de copolymères à blocs d'isobutylène par rapport à la proportion totale de copolymères à blocs représente au moins 40% en poids, de préférence au moins 55% en poids.

11. Utilisation selon l'une quelconque des revendications 6 à 10, **caractérisée en ce que** la masse autoadhésive contient une résine ou un mélange de résines, de préférence des résines hydrogénées présentant un degré d'hydrogénation d'au moins 90%, plus préférablement d'au moins 95%.

12. Utilisation selon l'une quelconque des revendications 6 à 11, **caractérisée en ce que** la masse auto adhésive contient au moins une résine, qui présente une valeur DACP (point de trouble dans le diacétone-alcool) supérieure à 30°C et une valeur MMAP (point de trouble dans un mélange de méthylcyclohexane et d'aniline) supérieure à 50°C, de préférence une valeur DACP supérieure à 37°C et une valeur MMAP supérieure à 60°C, et/ou **en ce que** la masse autoadhésive contient au moins une résine, qui présente une température de ramollissement supérieure à 95°C, en particulier supérieure à 100°C.

13. Utilisation selon l'une quelconque des revendications 6 à 12, **caractérisée en ce que** la masse autoadhésive contient un ou plusieurs additifs, de préférence choisis dans le groupe constitué par : les plastifiants, les antioxydants primaires, les antioxydants secondaires, les stabilisateurs de traitement, les agents de protection contre la lumière, les adjuvants de transformation, les résines de renforcement des blocs terminaux, les polymères, en particulier de nature élastomère.

14. Utilisation selon l'une quelconque des revendications 6 à 13, **caractérisée en ce que** la masse autoadhésive contient une ou plusieurs charges, de préférence des charges nanométriques, des charges transparentes et/ou des charges absorbantes et/ou désactivantes.

15. Utilisation selon l'une quelconque des revendications 6 à 14, **caractérisée en ce que** la masse autoadhésive est réalisée de manière transparente, de préférence **en ce que** la masse autoadhésive présente, dans la plage de longueurs d'ondes de 400 nm à 800 nm, un degré de transmission moyen d'au moins 75%, plus préférablement d'au moins 90%.

16. Utilisation selon l'une quelconque des revendications 6 à 15, **caractérisée en ce que** la masse autoadhésive est réalisée de manière à bloquer les UV dans la plage de longueurs d'ondes de 320 nm à 400 nm, de préférence dans la plage de longueurs d'ondes de 280 nm à 400 nm, plus préférablement dans la plage de longueurs d'ondes de 190 nm à 400 nm, où on désigne par un blocage des UV un degré de transmission moyen d'au maximum 20%, de préférence d'au maximum 10%, plus préférablement d'au maximum 1%.

17. Utilisation selon l'une quelconque des revendications 6 à 16, **caractérisée en ce que** la masse autoadhésive présente un WVTR (taux de transmission de la vapeur d'eau) inférieur à 40 g/m²*j, de préférence inférieur à 10 g/m²*j, de manière tout particulièrement préférée inférieur à 1 g/m²*j et/ou **en ce que** la masse autoadhésive présente un OTR (taux de transmission de l'oxygène) inférieur à 5000 g/m²*j*bar, de préférence inférieur à 3000 g/m²*j*bar.

18. Utilisation selon l'une quelconque des revendications 6 à 17, **caractérisée en ce que** la masse autoadhésive est réalisée sous forme de bande adhésive, en particulier sous forme de bande adhésive sans support.

19. Dispositif électronique présentant une structure électronique, en particulier une structure électronique organique et une masse autoadhésive, la structure électronique étant encapsulée en moins en partie par la masse autoadhésive, **caractérisé en ce que** la masse autoadhésive est réalisée selon l'une quelconque des revendications 6 à 18.
